(19) Europäisches Patentamt / European Patent Office / Office européen des brevets

(11) **EP 4 354 764 B1**

(12) **EUROPEAN PATENT SPECIFICATION**

(45) Date of publication and mention of the grant of the patent:
**10.09.2025 Bulletin 2025/37**

(21) Application number: **22836893.2**

(22) Date of filing: **05.07.2022**

(51) International Patent Classification (IPC):
**H04B 10/40** (2013.01)     **H03F 3/08** (2006.01)
**H04B 10/69** (2013.01)

(52) Cooperative Patent Classification (CPC):
**H04B 10/6933; H03F 3/087; H03F 2200/375**

(86) International application number:
**PCT/CN2022/103815**

(87) International publication number:
**WO 2023/280142 (12.01.2023 Gazette 2023/02)**

(54) **DC OFFSET CURRENT CANCELLATION CIRCUIT AND METHOD, RELATED DEVICE, AND SYSTEM**

SCHALTUNG UND VERFAHREN ZUR UNTERDRÜCKUNG VON GLEICHSTROMOFFSETSTROM, ZUGEHÖRIGE VORRICHTUNG UND SYSTEM

CIRCUIT ET PROCÉDÉ D'ANNULATION DE COURANT DE DÉCALAGE CONTINU, DISPOSITIF ASSOCIÉ ET SYSTÈME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.07.2021 CN 202110764123**

(43) Date of publication of application:
**17.04.2024 Bulletin 2024/16**

(73) Proprietor: **Huawei Technologies Co., Ltd.**
**Shenzhen, Guangdong 518129 (CN)**

(72) Inventors:
• **JING, Lei**
  **Shenzhen, Guangdong 518129 (CN)**
• **HUANG, Wei**
  **Xianning West Road Xi'an, Shaanxi 710049 (CN)**
• **LI, Dan**
  **Xianning West Road Xi'an, Shaanxi 710049 (CN)**

(74) Representative: **Körber, Martin Hans**
**Mitscherlich PartmbB**
**Patent- und Rechtsanwälte**
**Karlstraße 7**
**80333 München (DE)**

(56) References cited:
WO-A1-2020/250846     CN-A- 104 734 645
CN-A- 107 134 984     CN-A- 108 322 265
CN-A- 110 535 534     JP-A- 2010 178 256
US-A1- 2011 031 419     US-A1- 2021 156 974

## Description

## TECHNICAL FIELD

Embodiments of this application relate to the communication field, and in particular, to a direct current offset current cancellation circuit and method, and a related device.

## BACKGROUND

The rapid development of optical fiber communication has greatly promoted the wide application of optical communication products. This imposes a strict requirement on performance of an optical communication product. In an optical receiver, an optical detector converts an optical signal into a current signal. An amplifier converts the current signal into a voltage signal and amplifies the voltage signal. The current signal output by the optical detector includes a direct current offset current and an alternating current. If there is a direct current offset current in a current input to the amplifier, the voltage signal output by the amplifier is distorted. Therefore, the direct current offset current in the current signal needs to be canceled, so that the voltage signal output by the amplifier is stable and accurate.

In conventional technologies, an offset voltage is extracted from a voltage signal output by an amplifier, the offset voltage is applied to a gate of a field effect transistor, and the field effect transistor is turned on to extract a direct current offset current from an input end of the amplifier, to cancel the direct current offset current. In this way, the direct current offset voltage applied to the gate of the field effect transistor has a process of slowly increasing from zero to the offset voltage, resulting in a slow turn-on speed of the field effect transistor and a slow extraction speed of the direct current offset current.

JP 2010 178256 A discloses an optical receiving technique for performing digital signal transmission in an optical communication system. After converting an optical signal into an electric signal (current signal) by a photoelectric conversion unit (PD 111) a part of the obtained current signal is subtracted by current source 112 and the residue is input into an amplifier 120. In the amplifier 120, an impedance conversion amplifier 121 converts the current signal into a voltage signal, and an amplifier 123 amplifies the voltage signal. A signal detector 124 detects the presence or absence of the voltage signal, and an automatic offset compensation circuit 125 integrates the voltage signal. If it is detected that the voltage signal is not present, the automatic offset compensation circuit 125 integrates the signal at a small time constant, and if it is detected that the voltage signal is present, the automatic offset compensation circuit 125 integrates the signal at a large time constant. A subtracting amount by the current source 112 is controlled depending on an output (integration value) of the automatic offset compensation circuit 125.

US 2011/031419 A1 discloses a current-voltage converting circuit (2) which is provided with a first feedback circuit (5) and a correcting transistor (Q1). The first feedback circuit (5) outputs, of an output voltage (V10), a voltage according to a magnitude of a low-frequency component that is not greater than or equal to a predefined first cut-off frequency. The correcting transistor (Q1) extracts a correction current (I21) according to a magnitude of an output of the first feedback circuit (5) from a sensor current (I10). The first feedback circuit (5) has a first integrating circuit (9) and a sample-and-hold circuit (10). The first integrating circuit (9) integrates the output voltage (V10) of a conversion section (3). The sample-and-hold circuit (10) samples and holds an output of the first integrating circuit (9) during a sensing period at which a pulsed detection signal is inputted.

## SUMMARY

Embodiments of this application provide a direct current offset current cancellation circuit and method, a related device, and a system, to quickly and accurately cancel a direct current offset current output by an optical detection module.

A first aspect of embodiments of this application provides a direct current offset current cancellation circuit. The cancellation circuit includes an optical detection module, a first amplification module, a first filtering module, an acceleration module, a charging module, and a direct current cancellation module. The optical detection module has an output end that is connected to a first end of the direct current cancellation module and the first amplification module. The first filtering module is connected to the first amplification module and the charging module. A second end of the direct current cancellation module is separately connected to the acceleration module and the charging module. A third end of the direct current cancellation module is grounded. The optical detection module is configured to receive an optical signal and convert the optical signal into a current signal. The first amplification module is configured to receive the current signal, convert and amplify the current signal into a voltage signal. The first filtering module is configured to filter the voltage signal to obtain a direct current offset voltage. The acceleration module is configured to accelerate a charging rate of the charging module by sharing an electric charge to the charging module in order to provide a target voltage for the charging module. The charging module comprises a capacitor connected between the second end of the direct current cancellation module and ground and is configured to output a cancellation voltage to the direct current cancellation module based on the target voltage and the direct current offset voltage. The cancellation voltage is positively correlated with the target voltage and the direct current offset voltage. The direct current cancellation module is configured to turn on the first end and the third end of the direct current cancellation module based on the cancellation voltage, so that the direct current offset current in the current signal is grounded through the first end and the third end of the direct current cancellation module. Sharing electric charge to the charging module through the acceleration module is equivalent to outputting an initial voltage to the charging module, so that a voltage of the charging module increases rapidly, thereby improving charging efficiency of the charging module, and accelerating a speed at which the cancellation voltage reaches the direct current offset voltage. In addition, because the cancellation voltage is positively correlated with the target voltage and the direct current offset voltage, a larger direct current offset current in the current signal indicates a larger corresponding direct current offset voltage and a larger cancellation voltage, so that a direct current offset current flowing to the ground through the direct current cancellation module is also larger. The direct current offset current flowing to the ground through the direct current cancellation module is canceled, to achieve accurate cancellation of the direct current offset current.

In a possible design, the cancellation circuit in embodiments further includes the acceleration module. The acceleration module is configured to provide the target voltage for the charging module in a target status. The acceleration module has a plurality of statuses, the target status is one of the plurality of statuses, and different statuses correspond to different voltages. Different statuses of the acceleration module may provide different voltages for the charging module, to improve a charging rate of the charging module.

In a possible design, a value of the target voltage is positively correlated with a value of the direct current offset voltage. A larger direct current offset voltage indicates a longer time needed for charging the charging module. In this way, different target voltages are provided for different magnitudes of direct current offset voltages, so that charging rates of the charging module in various cases can be improved.

In a possible design, capacitance of the charging module is negatively correlated with the value of the target voltage. In this way, it is ensured that time constants of the charging module and the acceleration module are kept unchanged, and a charging rate of the direct current offset voltage for the charging module is not reduced when capacitance in the charging module increases.

In a possible design, the cancellation circuit in embodiments further includes a deceleration module. The deceleration module is connected to the first filtering module. The deceleration module is configured to control a time constant for the first filtering module to filter the voltage signal. When the time constant for the first filtering module to filter the voltage signal is reduced, the cancellation voltage can quickly reach the direct current offset voltage. When the time constant for the first filtering module to filter the voltage signal is increased, the cancellation circuit is more stable, and baseline drift is suppressed.

In a possible design, the cancellation circuit in embodiments further includes a starting module and a switch module. An input end of the starting module is connected to an output end of the first filtering module and an output end of the starting module is connected to a control end of the switch module. The switch module is connected between the first filtering module and the second end of the direct current cancellation module. The starting module is configured to: when determining that the direct current offset voltage is greater than or equal to a first reference voltage, turn on the switch module, to enable the first filtering module to be connected to the direct current cancellation module. The starting module can enable the cancellation circuit not to start the direct current cancellation module when the direct current offset voltage is not greater than the first reference voltage, thereby reducing interference to the optical detection module and improving a signal-to-noise ratio of a signal output by the optical detection module.

In a possible design, the cancellation circuit in embodiments further includes a second amplification module. The second amplification module is connected between the first filtering module and the direct current cancellation module. The second amplification module is configured to amplify the direct current offset voltage, and output an amplified direct current offset voltage to the charging module. The second amplification module increases a gain of the direct current offset voltage, so that precision of canceling the direct current offset current can be improved.

In a possible design, the cancellation circuit in embodiments further includes a second filtering module. The second filtering module is connected between the second amplification module and the direct current cancellation module. The second filtering module is configured to filter the amplified direct current offset voltage output by the second amplification module, and output a filtered direct current offset voltage to the charging module. The second filtering module makes a voltage delivered to the charging module more stable, so that the direct current offset current is stably canceled, and the voltage signal output by the first amplification module is accurate and stable.

A second aspect of embodiments of this application provides a direct current offset current cancellation method. The method is applied to a direct current offset current cancellation circuit. The cancellation circuit includes an optical detection module, a first amplification module, a first filtering module, an acceleration module, a charging module, and a direct current cancellation module. The optical detection module having an output end that is connected to a first end of the direct current cancellation module and the first amplification module. The first filtering module is connected to the first amplification module and the charging module. A second end of the direct current cancellation module is connected to the acceleration module and the charging module. A third end of the direct current cancellation module is grounded.

The method includes: The optical detection module receives an optical signal and converts the optical signal into a current signal. The first amplification module receives the current signal and converts the current signal into a voltage signal. The first filtering module filters the voltage signal to obtain a direct current offset voltage. The acceleration module accelerates a charging rate of the charging module by sharing an electric charge to the charging module (105) in order to provide a target voltage for the charging module. The charging module outputs a cancellation voltage to the direct current cancellation module based on the target voltage and the direct current offset voltage, where the cancellation voltage is positively correlated with the target voltage and the direct current offset voltage. The direct current cancellation module grounds, based on the cancellation voltage, a direct current offset current in the current signal through the first end and the third end of the direct current cancellation module.

In a possible design, that the acceleration module provides a target voltage for the charging module specifically includes: The acceleration module provides the target voltage for the charging module in a target status. The acceleration module has a plurality of statuses. The target status is one of the plurality of statuses, and different statuses correspond to different voltages.

In a possible design, the target status is a preset status of the acceleration module, and a value of the target voltage is a minimum value in a plurality of voltages corresponding to the plurality of statuses.

In a possible design, a value of the target voltage is positively correlated with a value of the direct current offset voltage.

In a possible design, the cancellation circuit further includes a deceleration module. The method further includes: The deceleration module controls a time constant for the first filtering module to filter the voltage signal.

A third aspect of embodiments of this application provides an optical receiver. The optical receiver includes a post amplification circuit and the direct current offset current cancellation circuit described in any one of the first aspect or specific designs of the first aspect. The post amplification circuit is connected to an output end of the direct current offset current cancellation circuit, and is configured to amplify a voltage signal output by the direct current offset current cancellation circuit. (excised)

## BRIEF DESCRIPTION OF DRAWINGS

FIG. 1 is a schematic diagram of a structure of a first embodiment of a direct current offset current cancellation circuit according to an embodiment of this application;
FIG. 2 is a schematic diagram of a structure of an acceleration module and a charging module in FIG. 1;
FIG. 3 is a schematic diagram of a structure of a second embodiment of a direct current offset current cancellation circuit according to an embodiment of this application;
FIG. 4 is a schematic diagram of a structure of a deceleration module in FIG. 3;
FIG. 5 is a schematic diagram of a structure of a third embodiment of a direct current offset current cancellation circuit according to an embodiment of this application;
FIG. 6 is a schematic diagram of a structure of a specific implementation of a direct current offset current cancellation circuit according to an embodiment of this application;
FIG. 7 is a schematic diagram of a structure of a fourth embodiment of a direct current offset current cancellation circuit according to an embodiment of this application;
FIG. 8 is a schematic diagram of a structure of a second amplification module in FIG. 7;
FIG. 9 is a schematic diagram of a structure of a fifth embodiment of a direct current offset current cancellation circuit according to an embodiment of this application;
FIG. 10 is a schematic diagram of a structure of an automatic gain control module according to an embodiment of this application;
FIG. 11 is a simulation diagram based on a fifth embodiment of a direct current offset current cancellation circuit according to this application;
FIG. 12 is another simulation diagram based on a fifth embodiment of a direct current offset current cancellation circuit according to this application; and
FIG. 13 is a schematic flowchart of an embodiment of a direct current cancellation method according to an embodiment of this application.

## DESCRIPTION OF EMBODIMENTS

Embodiments of this application provide a direct current offset current cancellation circuit and method, a related device, and a system, to cancel a direct current offset current output by an optical detector accurately and quickly.

A passive optical network (passive optical network, PON) includes an optical distribution network (optical distribution network, ODN), an optical line terminal (optical line terminal, OLT) on an office (central office) side, an optical network unit (optical network unit, ONU) on a user side, an optical network terminal (optical network terminal, ONT), or the like. The OLT provides a network-side interface for a PON system, and the ONU provides a user-side interface for the PON system. The ODN is a network including an optical fiber and a passive optical splitting device, and is configured to connect the OLT and the ONU, and distribute or multiplex a data signal between the OLT and the ONU.

A communication signal of each ONU is referred to as a burst optical signal (hereinafter referred to as an optical signal). An optical receiver on an OLT side should be capable of quickly capturing optical signals within a specific dynamic range.

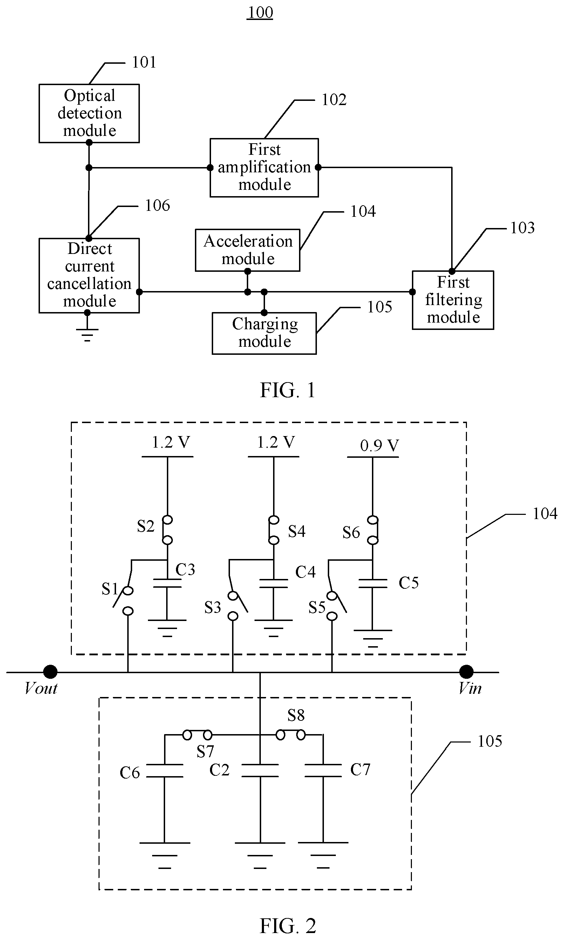

FIG. 1 is a schematic diagram of a structure of a first embodiment of a direct current offset current cancellation circuit according to this application. As shown in FIG. 1, the direct current offset current cancellation circuit 100 includes an optical detection module 101, a first amplification module 102, a first filtering module 103, an acceleration module 104, a charging module 105, and a direct current cancellation module 106. The optical detection module 101 is separately connected to a first end of the direct current cancellation module 106 and the first amplification module 102. The first filtering module 103 is connected to the first amplification module 102 and the charging module 105. A second end of the direct current cancellation module 106 is separately connected to the acceleration module 104 and the charging module 105. A third end of the direct current cancellation module 106 is grounded.

Specifically, an output end of the optical detection module 101 is separately connected to the first end of the direct current cancellation module 106 and an input end of the first amplification module 102. An output end of the first amplification module 102 is connected to an input end of the first filtering module 103, and an output end of the first filtering module 103 is separately connected to the second end of the direct current cancellation module 106, a first end of the charging module 105, and a first end of the acceleration module 104. The third end of the direct current cancellation module 106, a second end of the charging module 105, and a second end of the acceleration module 104 are grounded. The first amplification module 102, the first filtering module 103, the acceleration module 104, the charging module 105, and the direct current cancellation module 106 form an adaptive offset cancellation (adaptive offset cancellation, AOC) loop. The following describes components included in the AOC loop.

The optical detection module 101 may be a photodiode (photodiode, PD). The PD is a PN diode that works in a reversed bias state, for example, an avalanche photodiode (avalanche photodiode, APD) or a PIN diode. This is not limited in this application. The optical detection module 101 is configured to receive an optical signal and convert the optical signal into a current signal. It should be noted that a current signal output by the optical detection module 101 includes an alternating current and a direct current offset current.

The first amplification module 102 converts and amplifies the current signal output by the optical detection module 101 into a voltage signal, and outputs the voltage signal. The voltage signal includes an alternating voltage and a direct current offset voltage. The alternating voltage is output after the alternating current is converted and amplified by the first amplification module 102. The direct current offset voltage is output after the direct current offset current is converted and amplified by the first amplification module 102. The first amplification module 102 may be a trans-impedance amplifier (trans-impedance amplifier, TIA), a low-impedance amplifier, a high-impedance amplifier, or the like. This is not limited in this application.

The first filtering module 103 filters out the alternating voltage in the voltage signal output by the first amplification module 102, and outputs the direct current offset voltage. The first filtering module 103 includes a first filter 1031. The first filter 1031 may be a resistor-capacitor filter or an inductor-capacitor filter (not shown in the figure). Unless otherwise specified, the filter in this application may be a low-pass filter such as a resistor-capacitor filter, an inductor-capacitor filter, or a resistor-inductor-capacitor filter. This is not limited in this application.

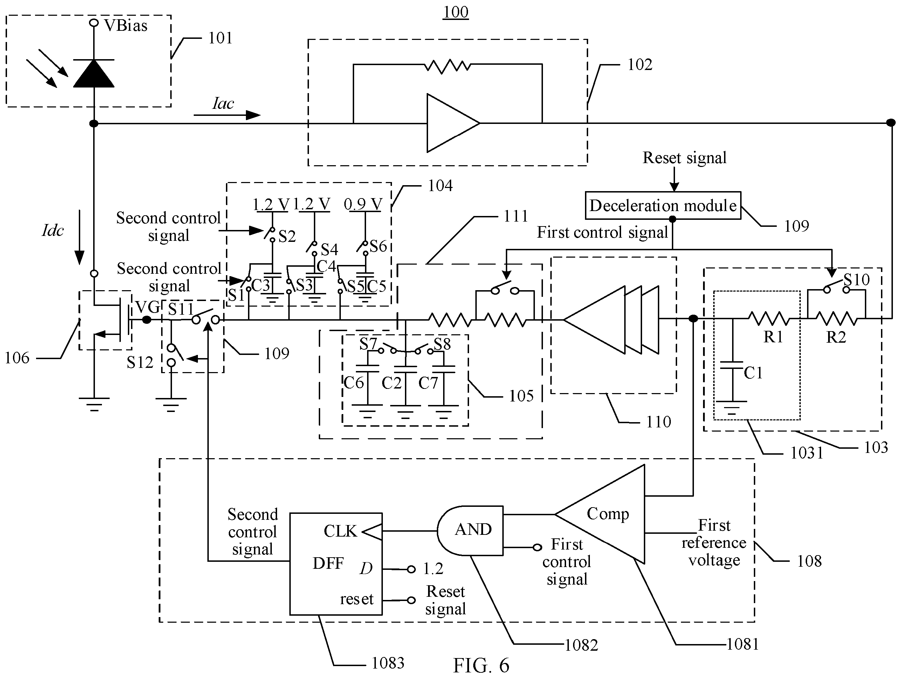

FIG. 6 is a schematic diagram of a structure of a specific implementation of a direct current offset current cancellation circuit according to an embodiment of this application. It should be noted that the direct current offset current cancellation circuit in FIG. 6 is merely used as an example, and is not used as a limitation on the technical solutions of this application. As shown in FIG. 6, when being a resistor-capacitor filter, the first filter 1031 may specifically include a first resistor R1 and a first capacitor C1. A first end of the first resistor R1 is connected to an output end of a first amplification module 102. A second end of the first resistor R1 is separately connected to a first end of the first capacitor C1, a second end of a direct current cancellation module 106, a first end of a charging module 105, and a first end of an acceleration module 104. A second end of the first capacitor C1 is grounded. The first filter 1031 may be a filter with a small time constant, to improve a rate of filtering a voltage signal. Specifically, resistance of the first resistor R1 may be any value between 3000 ohms and 8000 ohms, for example, 5000 ohms. A size of the first capacitor C1 may be any value between 200 farads and 300 farads, for example, 250 farads.

A direct current offset voltage output by the first filtering module 103 is used for charging the charging module 105. The charging module 105 can provide a cancellation voltage for the second end of the direct current cancellation module 106.

FIG. 2 is a schematic diagram of a structure of an acceleration module and a charging module according to this application. A quantity of capacitors of the acceleration module 104 and the charging module 105 in FIG. 2 is merely used as an example. Alternatively, there may be one, two, four, or more capacitors. This is not limited herein. As shown in FIG. 2, the charging module 105 includes, for example, a second capacitor C2. A first end of the second capacitor C2 is separately connected to the output end of the first filtering module 103, the second end of the direct current cancellation module 106, and the first end of the acceleration module 104. A second end of the second capacitor C2 is grounded. The second capacitor C2 charges the second capacitor C2 by using a direct current offset voltage output by the first filtering module 103. The second capacitor C2 is equivalent to a power supply, and can provide a voltage for the second end of the direct current cancellation module 106. A voltage of the second capacitor C2 is the same as a voltage (a cancellation voltage) of the second end of the direct current cancellation module 106.

In an initial phase of generating the direct current offset voltage, due to a capacitance characteristic of the second capacitor C2 in the charging module 105, there is a transition process for the direct current offset voltage from charging the charging module 105 from 0 volt (V) to finally achieving consistency between a voltage of the charging module 105 and the direct current offset voltage. In other words, the voltage of the charging module 105 does not reach a value of the direct current offset voltage instantly from 0 V, but slowly increases from 0 V to the value of the direct current offset voltage. It takes a long time to charge the voltage of the charging module 105 to the direct current offset voltage. Therefore, in this application, the acceleration module 104 is configured to accelerate a charging rate of the charging module 105.

Specifically, as shown in FIG. 2, the acceleration module 104 includes a third capacitor C3, a first switch S1, and a second switch S2. A first end of the third capacitor C3 is separately connected to the first end of the second capacitor C2 and the second end of the direct current cancellation module 106 through the first switch S1. The first end of the third capacitor C3 is further connected to a first power supply through the second switch S2, and a second end of the third capacitor C3 is grounded. When the first switch S1 is open and the second switch S2 is closed, the first power supply provides a first preset voltage for the third capacitor C3, to enable the first end of the third capacitor C3 to store electric charge.

When the first switch S1 is closed and the second switch S2 is open, the first end of the second capacitor C2 is connected to the first end of the third capacitor C3. The third capacitor C3 charges the second capacitor C2 to provide a target voltage. A process in which the third capacitor C3 charges the second capacitor C2 may be actually explained as a process in which the third capacitor C3 shares electric charge with the second capacitor C2. Specifically, that the first end of the second capacitor C2 is connected to the first end of the third capacitor C3 is equivalent to that the second capacitor C2 and the third capacitor C3 are connected in parallel. Because electric charge at the first end of the second capacitor C2 is 0 in an initial phase, and a quantity of electric charge at the first end of the third capacitor C3 is greater than a quantity of electric charge at the first end of the second capacitor C2, the electric charge at the first end of the third capacitor C3 moves towards the first end of the second capacitor C2, and electric charge can be quickly balanced between the second capacitor C2 and the third capacitor C3. The first end of the second capacitor C2 stores electric charge, so that a voltage of the second capacitor C2 quickly changes from 0 V to the target voltage. Certainly, when the third capacitor C3 charges the second capacitor C2, the direct current offset voltage also charges the second capacitor C2. However, because the third capacitor C3 charges the second capacitor C2 for a short time, electric charge provided by the direct current offset voltage for the second capacitor C2 in this period may be ignored compared with electric charge provided by the third capacitor C3 for the second capacitor C2.

The formula for calculating the target voltage in the initial phase is as follows:

$$U = \frac{Q}{C} - U_2 = \frac{U_2 \cdot C_2 + U_3 \cdot C_3}{C_2 + C_3} - U_2$$

$U$ is the target voltage. $U_2$ is the initial voltage of C2 and is considered as 0 V. $C_2$ is capacitance of C2. $U_3$ is the first preset voltage of C3. $C_3$ is capacitance of C3. $Q$ is a total quantity of electric charge of C2 and C3. $C$ is total capacitance of C2 and C3. Because C2 and C3 are connected in parallel, $Q$ is a sum of the quantity of electric charge of C2 and the quantity of electric charge of C3, and $C$ is a sum of the capacitance of C2 and the capacitance of C3.

In this embodiment of this application, the acceleration module 104 charges the charging module 105, to enable the voltage of the charging module 105 to reach the target voltage instantly. This is equivalent to providing an initial voltage for the charging module 105. A time that the charging module 105 needs to be charged from the direct current offset voltage to the target voltage from 0 V is reduced, and the charging rate of the charging module 105 is accelerated, so that a value of the voltage of the charging module 105 can reach the value of the direct current offset voltage more quickly.

To enable the voltage of the charging module 105 to be the same as the direct current offset voltage after being stabilized, the target voltage provided by the acceleration module 104 is not greater than the direct current offset voltage. The direct current offset voltage is positively correlated with a direct current offset current output by the optical detection module 101, and the direct current offset current is positively correlated with strength of an optical signal. The optical signal has different strength, so the direct current offset voltage has different values. If the target voltage provided by the acceleration module 104 is excessively large, the target voltage may be greater than the direct current offset voltage when the direct current offset voltage is small. If the target voltage provided by the acceleration module 104 is excessively small, an acceleration degree of the acceleration module 104 is limited when the direct current offset voltage is large.

Therefore, the acceleration module 104 in this embodiment of this application may further have a plurality of statuses, to provide a corresponding voltage for the charging module 105. A target status is determined from the plurality of statuses of the acceleration module 104, to provide a corresponding target voltage for the charging module 105. Each status corresponds to a capacitor that carries a different quantity of electric charge in the acceleration module 104 and that is connected to the charging module 105. Specifically, for example, the acceleration module 104 has different quantities of capacitors connected to the charging module in different statuses.

The target status of the acceleration module 104 may be a preset status. The preset status is a default initial status. To ensure that the target voltage is not greater than the direct current offset voltage, a target voltage corresponding to the preset status is the minimum in a plurality of voltages. Refer to FIG. 2. The preset status is, for example, a status in which C3 is connected to C2 when the first switch S1 is closed and the second switch S2 is open.

In a status other than the preset status in the plurality of statuses of the acceleration module 104, a value of a voltage corresponding to the status is positively correlated with the value of the direct current offset voltage. In other words, a larger direct current offset voltage indicates a larger target voltage provided by the acceleration module 104.

Another status of the acceleration module 104 may be switched based on the preset status. Specifically, the acceleration module 104 includes a plurality of capacitors carrying electric charge. When the preset status is switched to another status, one or more capacitors carrying electric charge are added to connect to the charging module 105 based on the preset status.

In this embodiment, an example in which the acceleration module 104 includes three statuses, that is, the preset status, a first dynamic status, and a second dynamic status, is used for description. As shown in FIG. 2, the acceleration module 104 includes a third capacitor C3, a first switch S1, a second switch S2, a fourth capacitor C4, a third switch S3, a fourth switch S4, a fifth capacitor C5, a fifth switch S5, and a sixth switch. A connection manner of the third capacitor C3, the first switch S1, and the second switch S2 is the same as that described above. Therefore, details are not described herein again. A first end of the fourth capacitor C4 is separately connected to the first end of the second capacitor C2, the first end of the third capacitor C3, and the second end of the direct current cancellation module 106 through the third switch S3. The first end of the fourth capacitor C4 is further connected to a second power supply through the fourth switch S4. A second end of the fourth capacitor C4 is grounded. A first end of the fifth capacitor C5 is separately connected to the first end of the second capacitor C2, the first end of the third capacitor C3, the first end of the fourth capacitor C4, and the second end of the direct current cancellation module 106 through the fifth switch S5. The first end of the fifth capacitor C5 is further connected to a third power supply through the sixth switch. A second end of the fifth capacitor C5 is grounded.

When the direct current offset current cancellation circuit 100 does not receive an optical signal, the first switch S1, the third switch S3, and the fifth switch S5 are open, and the second switch S2, the fourth switch S4, and the sixth switch S6 are closed. In this case, the first power supply provides the first preset voltage for the third capacitor C3, to enable the first end of the third capacitor C3 stores electric charge; the second power supply provides a second preset voltage for the fourth capacitor C4, to enable the first end of the fourth capacitor C4 stores electric charge; and the third power supply provides a third preset voltage for the fifth capacitor C5, to enable the first end of the fifth capacitor C5 stores electric charge. The first preset voltage, the second preset voltage, and the third preset voltage may be all the same, partially the same, or completely different. When the direct current offset current cancellation circuit 100 receives the optical signal, it is determined, based on the target status, whether the first switch S1 to the sixth switch S6 are closed or open.

Optionally, to enable an electric potential difference between the acceleration module 104 and the charging module 105, so that the acceleration module 104 can provide more electric charge for the charging module 105, the first preset voltage, the second preset voltage, and the third preset voltage each may be greater than the direct current offset voltage. Certainly, the first preset voltage to the third preset voltage may not be greater than the direct current offset voltage, provided that an initial voltage of the acceleration module 104 is greater than the voltage of the charging module 105 when the acceleration module 104 is in the target status.

In the preset status, the first switch S1, the fourth switch S4, and the sixth switch are closed, the second switch S2, the third switch S3, and the fifth switch S5 are open, the first end of the third capacitor C3 is connected to the first end of the second capacitor C2, and the third capacitor C3 charges the second capacitor C2 to provide a target voltage.

In the first dynamic status, the first switch S1, the third switch S3, and the sixth switch are closed, the second switch S2, the fourth switch S4, and the fifth switch S5 are open, the first end of the fourth capacitor C4 is connected to the first end of the second capacitor C2 and the first end of the third capacitor C3, and the fourth capacitor C4 charges the second capacitor C2 to provide a target voltage.

In the second dynamic status, the first switch S1, the third switch S3, and the fifth switch S5 are closed, the second switch S2, the fourth switch S4, and the sixth switch are open, the first end of the fifth capacitor C5 is connected to the first end of the second capacitor C2, the first end of the third capacitor C3 is connected to the first end of the fourth capacitor C4, and the fifth capacitor C5 charges the second capacitor C2 to provide a target voltage.

It should be noted that the target voltage in this embodiment of this application is an increased voltage of the charging module 105 based on a quantity of electric charge, where the quantity of charge is a quantity of electric charge provided by the acceleration module 104 as a whole for the charging module 105 in an entire process of accelerating the charging module 105 by the acceleration module 104. For example, in the preset status, C3 has first charged C2 and balance is reached, and when the second dynamic status is subsequently switched, C4 continues to charge C2. In this case, the target voltage in the first dynamic status is a voltage that increases in C2 due to a sum of quantities of electric charge provided by C3 and C4 for C2. Similarly, the target voltage in the second status refers to a voltage increased in C2 due to a sum of quantities of electric charge provided by C3, C4, and C5 for C2.

Because the acceleration module 104 connects capacitors with electric charge to the charging module 105 to charge the charging module 105, it is equivalent to that one or more capacitors are connected in parallel in the charging module 105. In this way, capacitance of the charging module 105 is increased, so that time constants of an AOC loop and the charging module 105 are increased, and a rate at which the direct current offset voltage charges the charging module 105 is slowed down to some extent. Therefore, in this embodiment of this application, in a process in which the acceleration module 104 is connected to a capacitor of target capacitance to charge the charging module 105, the target capacitance is subtracted from total capacitance of the charging module 105. Generally, when a preset voltage of each capacitor in the acceleration module 104 is fixed, larger capacitance of the capacitor connected to the charging module 105 by the acceleration module 104 indicates a larger quantity of electric charge that can be provided for the charging module 105, a larger target voltage that can be provided for the charging module 105, larger target capacitance that needs to be reduced by the charging module 105, and smaller remaining capacitance of the charging module 105.

There are a plurality of manners for reducing the capacitance of the charging module 105.

For example, a quantity of capacitors connected to the charging module 105 may be reduced. The charging module 105 further includes one or more parallel capacitors other than the second capacitor C2. A first end of each parallel capacitor is connected to the first end of the second capacitor C2 through a switch, and a second end of each parallel capacitor is grounded. In an initial status, a switch at the first end of each parallel capacitor is closed, and the second capacitor C2 is connected to the parallel capacitors in parallel. When the acceleration module 104 switches a status, and one or more capacitors are newly added to the acceleration module 104 to connect to the charging module 105, the charging module 105 disconnects one or more switches connected to the parallel capacitors, to reduce the capacitance of the charging module 105, so that reduced capacitance of the charging module 105 is the same as capacitance of the capacitors newly connected to the charging module 105 by the acceleration module 104.

For example, as shown in FIG. 2, the charging module 105 further includes, for example, a sixth capacitor C6, a seventh switch S7, a seventh capacitor, and an eighth switch S8. A first end of the sixth capacitor C6 is connected to the first end of the second capacitor C2 through the seventh switch S7. A first end of the seventh capacitor is connected to the first end of the second capacitor C2 through the eighth switch S8, and second ends of the sixth capacitor C6 and the seventh capacitor are grounded. Capacitance of the fourth capacitor C4, the fifth capacitor C5, the sixth capacitor C6, and the seventh capacitor each is, for example, 1.5 picofarads. In an initial status, the acceleration module 104 is in the preset status, the first switch S1, the seventh switch S7, and the eighth switch S8 are closed, the second switch S2 is open, the first end of the third capacitor C3 is connected to the first end of the second capacitor C2, the first end of the sixth capacitor C6, and the first end of the seventh capacitor, and the third capacitor C3 charges the second capacitor C2, the sixth capacitor C6, and the seventh capacitor. If the acceleration module 104 switches from the preset status to the first dynamic status, the third switch S3 is closed, the fourth switch S4 is open, the first end of the fourth capacitor C4 is connected to a first end of the charging module 105 to charge the charging module 105, and the charging module 105 disconnects the seventh switch S7. Capacitance of the acceleration module 104 is increased by 1.5 picofarads, and the capacitance of the charging module 105 is decreased by 1.5 picofarads. The acceleration module 104 switches from the first dynamic status to the second dynamic status in a similar way.

For another example, the second capacitor C2 is a variable capacitor. As capacitance of a capacitor that is in the acceleration module 104 and that is connected to the charging module 105 increases, the second capacitor C2 correspondingly decreases equal capacitance. In this case, the second capacitor C2 in the charging module 105 does not need to be connected to a capacitor in parallel.

Certainly, in a process of the acceleration module 104 switches a status, the capacitance of the charging module 105 may not be changed. A time constant of the AOC loop is kept unchanged by keeping the capacitance of the capacitor that is in the acceleration module 104 and that is connected to the charging module 105 unchanged, to ensure a charging rate of the direct current offset voltage to the charging module.

As shown in FIG. 2, for example, capacitance of C3, C4, and C5 each is 1.5 picofarads. In an initial status, the acceleration module 104 is in the preset status, the first switch S1 is closed, the second switch S2 is open, the first end of the third capacitor C3 is connected to the first end of the second capacitor C2, and the third capacitor C3 charges the second capacitor C2. Electric charge is quickly balanced between the third capacitor C3 and the second capacitor C2. If the acceleration module 104 switches from the preset status to a second status, the third switch S3 is closed, the fourth switch S4 is open, and the first end of the fourth capacitor C4 is connected to the first end of the charging module 105 to charge the charging module 105. In this process, the acceleration module 104 further disconnects the first switch S1 to disconnect the third capacitor C3 from the charging module 105. The fourth capacitor C4 is newly added to the acceleration module 104, and the capacitance is increased by 1.5 picofarads. The acceleration module 104 disconnects the third capacitor C3, and the capacitance is decreased by 1.5 picofarads. The capacitance of the acceleration module 104 is kept unchanged, and capacitance of the charging module 105 and the AOC loop are kept unchanged.

Alternatively, the target status of the acceleration module 104 may be directly determined, switching does not need to be performed based on a previous status (for example, the first dynamic status is switched based on the preset status, and the second dynamic status is switched based on the first dynamic status). Specifically, a value of the direct current offset voltage is positively correlated with the direct current offset current, and the direct current offset current is positively correlated with the strength of the optical signal. In other words, larger optical power of the optical signal indicates a larger direct current offset voltage, and a larger voltage that the acceleration module 104 needs to provide for the charging module 105. Therefore, the target status of the acceleration module 104 may be determined based on the optical power of the optical signal. In other words, the acceleration module 104 provides a corresponding quantity of electric charge for the charging module 105 at a time, and does not need to charge the charging module 105 in several times.

For example, a chip integrated in the AOC generates a reset (reset) signal based on the optical power. A magnitude of the optical power is positively correlated with a magnitude of a pulse width of the reset signal, or is positively correlated with a magnitude of a level of the reset signal. Further, the target status of the acceleration module 104 is determined based on the width and the level of the reset signal. For example, that the level of the reset signal is 0.1 decibels to 0.3 decibels (dB) (including 0.1 and 0.3) corresponds to a first status of the acceleration module 104. That the level of the reset signal is 0.4 dB to 0.6 dB (including 0.4 and 0.6) corresponds to a second status of the acceleration module 104. That the level of the reset signal is 0.7 dB to 1.0 dB (including 0.7 and 1) corresponds to a third status of the acceleration module 104. When the level of the reset signal is 0.8 dB, it is determined that the target status of the acceleration module 104 is the third status, and the acceleration module 104 is directly controlled to be in the third status, without switching from the first status to the second status and then switching from the second status to the third status.

The acceleration module 104 provides the target voltage for the charging module 105 in a plurality of manners. For example, different statuses of the acceleration module 104 correspond to different quantities of capacitors that are in the acceleration module 104 and that are connected to the charging module 105. The quantity of capacitors that are in the acceleration module and that are connected to the charging module 105 is controlled, to provide a corresponding target voltage for the charging module 105. Alternatively, the acceleration module 104 includes a plurality of capacitors that carry different quantities of electric charge, and each status corresponds to one of the capacitors that is connected to the charging module 105, to provide a corresponding target voltage for the charging module 105.

A cancellation voltage of the second end of the direct current cancellation module 106 is the same as the voltage of the charging module 105. A voltage of the charging module 105 in a charging process is determined by both the target voltage and the direct current offset voltage. A magnitude of the cancellation voltage is positively correlated with the target voltage and the direct current offset voltage.

The direct current cancellation module 106 may be a voltage-controlled current source. When a voltage at the second end of the direct current cancellation module 106 reaches a threshold, a first end and a third end of the direct current cancellation module 106 are turned on, so that at least a part of the direct current offset current in the current signal output by the optical detection module 101 flows to the ground through the first end and the third end of the direct current cancellation module 106, thereby canceling the at least a part of the direct current offset current in the current signal, and reducing a direct current offset current flowing into the first amplification module 102. The direct current cancellation module 106 may include a field effect transistor. The field effect transistor may be a type of P or N. This is not limited in this application. A relationship between the direct current offset current canceled by the direct current cancellation module 106 and the cancellation voltage is as follows:

$$I_{dc} = gm \cdot U_{VG}$$

$I_{dc}$ is the direct current offset current canceled by the direct current cancellation module 106, gm is transconductance of the field effect transistor, and $U_{VG}$ is the cancellation voltage.

As shown in FIG. 6, a P-type field effect transistor is used as an example for description. A gate of the field effect transistor is the second end of the direct current cancellation module 106, and a source and a drain are respectively the third end and the first end of the direct current cancellation module 106. The source and the drain of the field effect transistor have a characteristic of passing a direct current and blocking an alternating current. Therefore, a direct current in a current signal output by the optical detection module 101 can flow to the ground through the field effect transistor, and an alternating current in the current signal is input to the first amplification module 102.

Certainly, the direct current cancellation module 106 may alternatively be a current-controlled current source. The direct current cancellation module 106 includes, for example, a transistor (not shown) and a voltage-to-current converter (not shown). The transistor may be a type of NPN or PNP. This is not limited in this application.

Regardless of a type of the direct current cancellation module 106, the cancellation voltage controls electrical connection of the first end and the third end of the direct current cancellation module 106, and a magnitude of the direct current offset current flowing to the ground through the first end and the third end of the direct current cancellation module 106. Within a specific voltage range, a larger cancellation voltage indicates a larger direct current offset current flowing through the first end and the third end of the current cancellation module. When the cancellation voltage reaches the direct current offset voltage, theoretically, the direct current offset current in the current signal output by the optical detection module 101 is almost canceled. After the cancellation voltage is equal to the direct current offset voltage, the voltage at the second end of the direct current cancellation module 106 no longer increases, and is stable at a value corresponding to the direct current offset voltage. The direct current offset current extracted by the direct current cancellation module 106 from the current signal tends to be stable, and the voltage signal output by the first amplification module 102 is also more accurate and stable. Therefore, in this embodiment of this application, the acceleration module 104 is configured to increase the charging rate of the charging module 105, to enable the cancellation voltage to quickly reach the direct current offset voltage. In this way, the direct current offset current can be extracted more quickly and stably from the current signal by the direct current cancellation module, to achieve an objective of quickly and accurately canceling the direct current offset current.

A data frame corresponding to the optical signal received by the optical detection module 101 includes a preamble and data code. The preamble is encapsulated before the data code, the preamble indicates clock synchronization timing, and to-be-transmitted data is carried in the data code. Therefore, a time at which the optical detection module 101 receives an optical signal corresponding to the preamble is earlier than a time at which an optical signal corresponding to the data code is received, and a time at which a current signal corresponding to the preamble is input into the AOC loop is also earlier than a time at which a current signal corresponding to the data code is input into the AOC loop. In addition, compared with a voltage signal corresponding to a preamble output by the first amplification module 102, accuracy and stability of a voltage signal corresponding to data code have higher requirements.

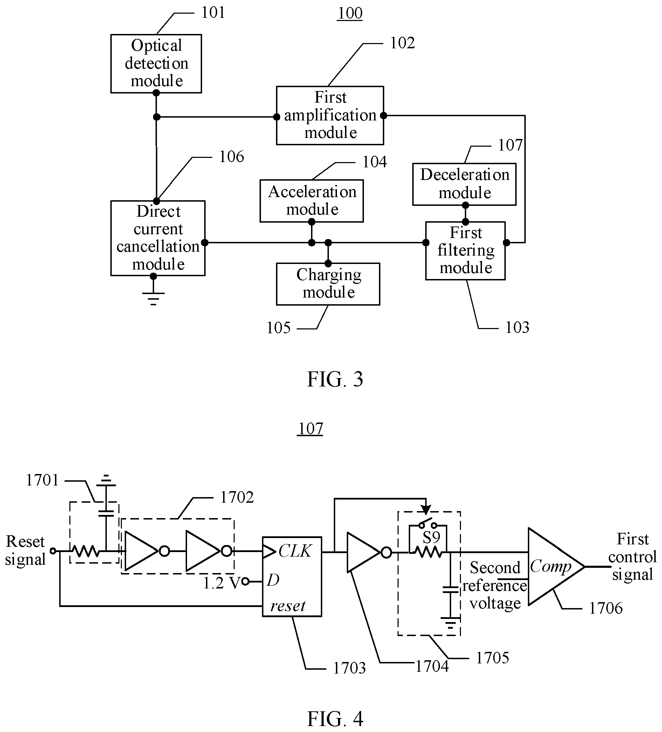

FIG. 3 is a schematic diagram of a structure of a second embodiment of a direct current cancellation circuit according to this application. Different from the first embodiment of the direct current offset current cancellation circuit 100, the cancellation circuit 100 in this embodiment further includes a deceleration module 107. As shown in FIG. 3, the deceleration module 107 is connected to a first filtering module 103, and is configured to control a time constant of the first filtering module 103, to control filtering duration of filtering a voltage signal.

Specifically, before a current signal corresponding to data code is input to an AOC loop, the deceleration module 107 controls the first filtering module 103 to be in a small time constant status, to reduce the filtering duration of the voltage signal, so that a cancellation voltage at a second end of a direct current cancellation module 106 can quickly reach a direct current offset voltage, and the AOC loop is quickly stable. When an optical detection module 101 outputs the current signal corresponding to the data code, the direct current cancellation module 106 can accurately extract a direct current offset current from the current signal, so that the current signal input to a first amplification module 102 is more accurate, and a voltage signal output by the first amplification module 102 is also more stable and accurate. A time constant of another module in the AOC loop is kept unchanged, and a time constant of the first filtering module 103 is changed. In other words, it is equivalent to changing a time constant of the AOC loop. It should be noted that a large time constant and a small time constant are relative to each other, and do not correspond to a specific time constant value.

When the current signal corresponding to the data code is input to the AOC loop, the deceleration module 107 controls the first filtering module 103 to be in a large time constant status. Compared with the small time constant status, the large time constant status increases the filtering duration of the voltage signal, and slows down a filtering speed of the voltage signal, so that stability of the AOC loop is improved, the voltage signal output by the first amplification module 102 is stable, and baseline drift is suppressed.

The deceleration module 107 controls switching between the large time constant and the small time constant of the first filtering module 103 by generating and outputting a first control signal to the first filtering module 103. The deceleration module 107 generates the first control signal by using a reset signal generated by a chip before the preamble arrives. The chip is a chip integrated by the deceleration module 107 and the AOC loop. A moment corresponding to a falling edge of the reset signal is the same as a moment corresponding to a rising edge of a first bit current signal of the preamble output by the optical detection module 101.

Specifically, the deceleration module 107 reshapes the reset signal, and delays the falling edge of the reset signal to obtain the first control signal. A moment corresponding to a falling edge of the first control signal is earlier than a moment corresponding to a rising edge of the current signal of the data code output by the optical detection module 101. When the first control signal is at a high level, the first filtering module 103 is in the small time constant status; when the first control signal is at a low level, the first filtering module 103 is in the large time constant status.

FIG. 4 is a schematic diagram of a structure of a deceleration module in FIG. 3. As shown in FIG. 4, the deceleration module 107 includes a second filter 1701, a shaper 1702, a first trigger 1703, a first inverter 1704, a third filter 1705, a first comparator 1076, and a ninth switch S9. An input end of the second filter 1701 is configured to receive a reset signal, and an output end of the second filter is connected to an input end of the shaper 1702. An output end of the shaper 1702 is connected to a clock control end of the first trigger 1703, a first input end is connected to a fourth power supply, a second input end is configured to receive the reset signal, and an output end is connected to an input end of the first inverter 1704 and a control end of the ninth switch S9. The fourth power supply is configured to maintain the first input end in a high-level state. An output end of the first inverter 1704 is connected to an input end of the third filter 1705. An output end of the third filter 1705 is connected to a first input end of the first comparator 1076. A second input end of the first comparator 1076 is configured to receive a second reference voltage, and an output end of the first comparator 1076 is connected to the first filtering module 103. One end of the ninth switch S9 is connected to the input end of the third filter 1705, and another end of the ninth switch is connected to the output end of the third filter. The first trigger 1703 is a falling-edge trigger.

A time constant of the second filter 1701 is less than a time constant of the third filter 1705. A main function of the second filter 1701 is to enable a falling edge of the reset signal to reach the clock control end of the first trigger later than the falling edge of the reset signal to reach the second input end of the first trigger. Therefore, when the falling edge of the reset signal reaches the clock control end of the first trigger, the second input end of the first trigger is restored to a low level.

A process of generating the first control signal is as follows. When a rising edge of the reset signal is input to the second input end of the first trigger 1703, the output end of the first trigger 1703 is triggered to output a first falling edge signal. The first falling edge signal triggers the ninth switch S9 to be closed, to short-circuit the third filter 1705. The first inverter 1704 inverts the first falling edge signal to a first rising edge signal, and inputs the first rising edge signal to the first input end of the first comparator 1076 through the ninth switch S9. The first comparator 1076 compares the first rising edge signal with the second reference voltage, and outputs a rising edge of the first control signal when a value of the first rising edge signal is greater than a value of the second reference voltage. When the falling edge of the reset signal arrives, the second input end of the first trigger 1703 is restored to a low level. The second filter 1701 delays the falling edge of the reset signal for the first time. Because the falling edge of the reset signal input by the second filter 1701 slows down, a waveform of the reset signal is no longer presented as a square wave. Therefore, a delayed and slowed falling edge of the reset signal is shaped by the shaper 1702 and output as a falling edge of the square wave. A shaped falling edge of the reset signal is input to the clock control end of the first trigger 1703. Because the first input end of the first trigger 1703 is at a high level and the second input end of the first trigger is at a low level, the shaped falling edge of the reset signal triggers the first trigger 1703 to output a second rising edge signal. The second rising edge signal triggers the ninth switch S9 to be open. The third filter 1705 is connected to the output end of the first inverter 1704. The first inverter 1704 inverts the second rising edge signal to a second falling edge signal, and inputs the second falling edge signal to the third filter 1705. The third filter 1705 delays the second falling edge signal, and outputs a delayed second falling edge signal to the first input end of the first comparator 1076. The first comparator 1076 compares the second falling edge signal with the second reference voltage, and outputs a falling edge of the first control signal when a voltage value of the second falling edge signal is less than the voltage value of the second reference voltage.

The first control signal may control the switching between a large time constant and a small time constant of the first filtering module 103 by changing resistance of the first filtering module 103. In this embodiment, an example in which the first filtering module 103 is a resistor-capacitor filter is used for description.

For example, the resistance of the first filtering module 103 may be changed by increasing or decreasing a quantity of resistors that are in the first filtering module 103 and that are connected to an AOC loop. As shown in FIG. 6, the first filtering module 103 includes, for example, a first resistor R1, a second resistor R2, a tenth switch S10, and a first capacitor C1. An input end of the second resistor R2 is connected to an output end of a first amplification module 102, and an output end of the second resistor R2 is connected to an input end of the first resistor R1. An output end of the first resistor R1 is separately connected to a first end of the first capacitor C1, a first end of a charging module 105, a first end of an acceleration module 104, and a second end of a direct current cancellation module 106. A second end of the first capacitor C1 is grounded. One end of the tenth switch S10 is connected to the input end of the second resistor R2, and another end of the tenth switch is connected to the output end of the second resistor R2. A control end of the tenth switch S 10 is connected to a deceleration module 107.

After the control end of the tenth switch S10 receives a first control signal sent by the deceleration module 107, the control end of the tenth switch S 10 is in a high-level state, and triggers the tenth switch S10 to be closed to short-circuit the first resistor R1. In this case, resistance of the first filtering module 103 becomes smaller, and a time constant becomes smaller, so that the first filtering module and an AOC loop are in a small time constant state.

After the first control signal disappears, the control end of the tenth switch S10 is restored to a low-level state, and triggers the tenth switch S10 to be open, and the first resistor R1 is connected to the AOC loop. In this case, the resistance of the first filtering module 103 becomes larger, and the time constant becomes larger, so that the first filtering module and the AOC loop are in a large time constant state.

For another example, the resistance of the first filtering module 103 may be changed by changing resistance of a resistor in the first filtering module 103. The first filtering module 103 includes, for example, a first resistor R1 and a first capacitor C1. A first end of the first resistor R1 is connected to an output end of a first amplification module 102. A second end of the first resistor R1 is separately connected to a first end of the first capacitor C1, a second end of a direct current cancellation module 106, a first end of a charging module 105, and a first end of an acceleration module 104. A second end of the first capacitor C1 is grounded. The first resistor R1 is a variable resistor. The first resistor R1 is further connected to an output end of a deceleration module 107. When the first resistor R1 receives a first control signal, resistance of the first resistor R1 is reduced, to enable the first filtering module 103 to be in a small time constant state. When the first control signal disappears, the resistance of the first resistor R1 is increased, to enable the first filtering module 103 to be in a large time constant state.

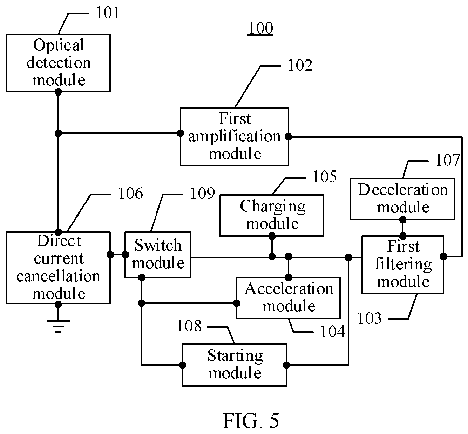

FIG. 5 is a schematic diagram of a structure of a third embodiment of a direct current offset current cancellation circuit according to an embodiment of this application. As shown in FIG. 5, the cancellation circuit 100 further includes a starting module 108 and a switch module 109. The starting module 108 is configured to control opening and closing of the switch module 109, to control whether an AOC loop works. When starting to receive an optical signal, an optical detection module 101 is very sensitive to noise in a circuit. If the AOC loop works at this time, the optical detection module 101 receives unnecessary noise. In the embodiment shown in FIG. 5, a signal-to-noise ratio of a current signal output by the optical detection module 101 can be improved.

Specifically, as shown in FIG. 5, an input end of the starting module 108 is connected to an output end of a first filtering module 103. An output end of the starting module 108 is connected to a control end of the switch module 109, and the switch module 109 is connected between the first filtering module 103 and a second end of a direct current cancellation module 106. The starting module 108 obtains a direct current offset voltage from the first filtering module 103, and compares the direct current offset voltage with a first reference voltage. When the direct current offset voltage is greater than the first reference voltage, a second control signal is output. The second control signal is used for controlling the switch module 109 to turn on the first filtering module 103 and the second end of the direct current cancellation module 106, to start the AOC loop, so that the AOC loop works. When the direct current offset voltage is not greater than the first reference voltage, the switch module 109 is in an open state, the first filtering module 103 is disconnected from the second end of the direct current cancellation module 106, and the AOC loop does not work.

As shown in FIG. 6, a starting module 108 may include a second comparator 1081, an AND gate unit 1082, and a second trigger 1083. A switch module 109 may include an eleventh switch S11 and a twelfth switch S12. A first input end of the second comparator 1081 is connected to an output end of the first filtering module 103. A second input end of the second comparator 1081 is configured to receive a preset voltage. An output end of the second comparator 1081 is connected to a first input end of the AND gate unit 1082. A second input end of the AND gate unit 1082 is connected to the output end of the deceleration module 107, and is configured to receive a first control signal. An output end of the AND gate unit 1082 is connected to a clock control end of the second trigger 1083. A first input end of the second trigger 1083 is connected to a fifth power supply, a second input end of the second trigger 1083 is configured to receive a reset signal, and an output end of the second trigger 1083 is connected to control ends of the eleventh switch S11 and the twelfth switch S12. The second trigger 1083 is a rising-edge trigger. The fifth power supply is configured to keep the first input end of the second trigger 1083 at a high level. One end of the eleventh switch S11 is connected to a first end of a charging module 105, a first end of an acceleration module 104, and a first end of the first filtering module 103. Another end of the eleventh switch S11 is connected to one end of the twelfth switch S12 and a second end of a direct current cancellation module 106. Another end of the twelfth switch S 12 is grounded.

The second comparator 1081 compares a direct current offset voltage with a first reference voltage. When the direct current offset voltage is greater than the first reference voltage, the second comparator 1081 outputs a first high level signal to the AND gate unit 1082. When the first high level signal received by the first input end of the AND gate unit 1082 is at a high level, and the first control signal received by the second input end of the AND gate unit 1082 is also at a high level, a third rising edge signal is output to the clock control end of the second trigger 1083. Because the first input end of the second trigger 1083 is at a high level, the third rising edge signal triggers the second trigger 1083 to output a second high level signal. The second high level signal is used for controlling the eleventh switch S11 to be closed and the twelfth switch S 12 to be open, so that the second end of the direct current cancellation module 106 is connected to the first end of the charging module 105, the first end of the acceleration module 104, and the first end of the first filtering module 103, to start the AOC loop.

The AND gate unit 1082 outputs the third rising edge signal only when both the first high level signal and the first control signal are valid, to prevent the AOC loop from being started due to an incorrect output current signal when an optical detection module 101 receives noise without receiving a burst signal. The first control signal is generated when the optical detection module 101 receives the burst signal. Therefore, the starting module 108 uses the first control signal as a necessary condition to ensure that the AOC loop is not started at an incorrect time. The second comparator 1081 outputs the first high level signal. In an aspect, it indicates that the direct current offset voltage, that is, a direct current offset current, is large, and the AOC loop needs to be started to cancel the direct current offset current. In another aspect, it indicates that strength of the current signal output by the optical detection module 101 is large, and in this case, noise caused by starting the AOC loop has a small impact on the optical detection module 101, and the AOC loop may be started.

The second control signal may be further used for controlling the acceleration module 104 to be in a preset status. An output end of the starting module 108 is further connected to control ends of a first switch S1 and a second switch S2. When the first switch S1 and the second switch S2 receive the second control signal, the first switch S1 is closed, and the second switch S2 is open, so that a second capacitor C2 is connected to the charging module 105, to provide a target voltage for the charging module 105.

The twelfth switch S12 is closed under control of the reset signal that arrives after the optical signal ends, to release electric charge in the charging module 105 to the ground, so that a voltage of the charging module 105 is restored to an initial status, that is, 0 V, before a next optical signal arrives.

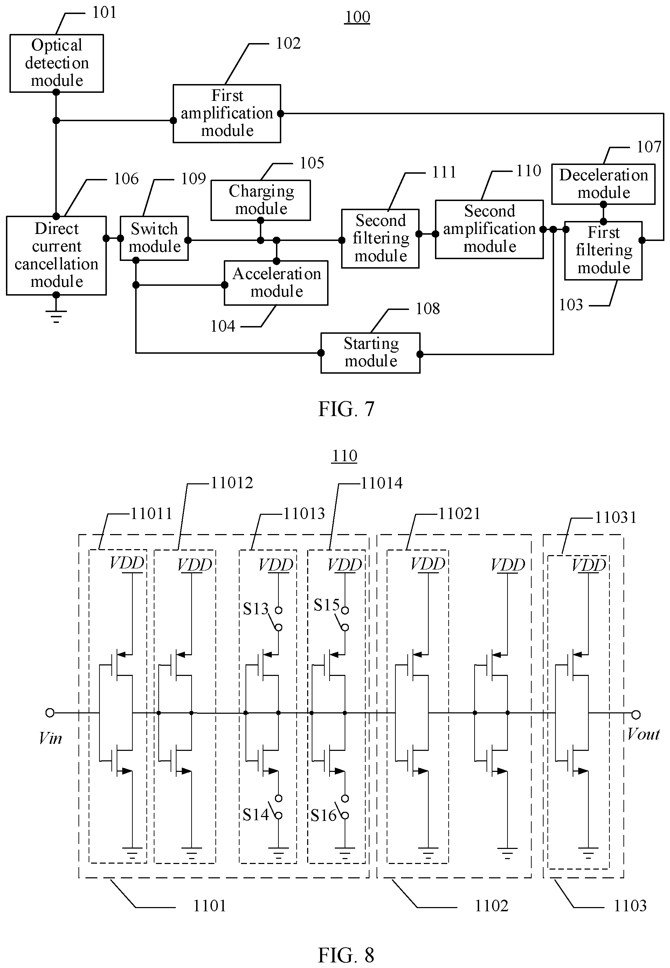

FIG. 7 is a schematic diagram of a structure of a fourth embodiment of a direct current offset current cancellation circuit according to an embodiment of this application. FIG. 8 is a schematic diagram of a structure of a second amplification module in FIG. 7. As shown in FIG. 7, the direct current offset current cancellation circuit 100 in this embodiment further includes a second amplification module 110. The second amplification module 110 is connected between a first filtering module 103 and a first end of a charging module 105. Specifically, an input end of the second amplification module 110 is connected to an output end of the first filtering module 103. An output end of the second amplification module 110 is connected to the first end of the charging module 105.

The second amplification module 110 is configured to amplify a direct current offset voltage output by the first filtering module 103, and output an amplified direct current offset voltage to the charging module 105. The second amplification module 110 can increase a range of the direct current offset voltage, so that a magnitude of a direct current extracted by a direct current cancellation module 106 can be more accurately controlled.

To improve a stable rate of an AOC loop, the second amplification module 110 may be a high-speed amplifier. As shown in FIG. 8, the second amplification module 110 may include a plurality of inverters, and each inverter is formed by connecting one P-type field effect transistor and one N-type field effect transistor in parallel. Input ends of the inverter are gates of two field effect transistors, and output ends of the inverter are drains of the two field effect transistors. A first source of the N-type field effect transistor in the inverters is connected to a working voltage, and a second source of the P-type field effect transistor is grounded. When the two field effect transistors in the inverter work in a saturation region, an amplification function can be implemented.

The second amplification module 110 may increase a gain of the AOC loop in a manner of cascading three levels of inverters, so that the loop cancels a direct current accurately. An input end of a first-level inverter 1101 is connected to the output end of the first filtering module 103. An output end of the first-level inverter 1101 is connected to an input end of a second-level inverter 1102. An output end of the second-level inverter 1102 is connected to an input end of a third-level inverter 1103. An output end of the third-level inverter 1103 is connected to the first end of the charging module 105.

Each level of inverter may include one inverter and at least one load. The at least one load in each level of inverter is connected in parallel with the inverter of the stage to amplify the direct current offset voltage. The first-level inverter 1101 and the second-level inverter 1102 are configured to stabilize a common-mode point. The third-level inverter 1103 may use a large size to ensure a high amplification speed.

For example, the first-level inverter 1101 includes a first inverter 11011, a first load 11012, a second load 11013, and a third load 11014, the second-level inverter 1102 includes a second inverter 11021 and two loads, and the third-level inverter 1103 includes a third inverter 11031. Certainly, a quantity of loads in the first-level inverter 1101 may be two, four, or more. Alternatively, a quantity of loads in the second-level inverter 1102 may be two, three, or more. This is not limited in this application. The third-level inverter 1103 may also include one or more loads.

In a case that an optical detection module 101 is switched from a 10G mode to a 2.5G mode or is in a slow-slow corner (slow-slow corner, SScorner), because a gain of a first amplification module 102 increases, to keep an overall gain of the AOC loop unchanged, a gain of the second amplification module 110 may be reduced, to ensure stability of the AOC loop.

The second amplification module 110 may support at least two gain modes. Specifically, the gain of the second amplification module 110 may be adjusted by adjusting a gain of the first-level inverter 1101. In this embodiment, an example in which the first-level inverter 1101 supports three gain modes is used for description. Certainly, the first-level inverter 1101 may further support two, four, or more gain modes, which may be specifically determined based on the quantity of loads in the first-level inverter 1101 and an actual gain requirement. This is not limited in this application.

As shown in FIG. 8, the first-level inverter 1101 further includes a thirteenth switch S13, a fourteenth switch S14, a fifteenth switch S15, and a sixteenth switch S16. A first source of the second load 11013 is connected to a sixth power supply through the thirteenth switch S13. A second source of the second load 11013 is grounded through the fourteenth switch S14. A first source of the third load 11014 is connected to a seventh power supply through the fifteenth switch S15. A second source of the third load 11014 is grounded through the sixteenth switch S16. The sixth power supply is configured to provide a working voltage for the second load 11013. The seventh power supply is configured to provide a working voltage for the third load 11014.

When the second amplification module 110 is in a high gain mode, the thirteenth switch S13, the fourteenth switch S14, the fifteenth switch S15, and the sixteenth switch S16 are all closed. When the second amplification module 110 is in a medium gain mode, the thirteenth switch S13 and the fourteenth switch S14 are open, so that the second load 11013 does not work, and the fifteenth switch S15 and the sixteenth switch S16 are closed. When the second amplification module 110 is in a low gain mode, the thirteenth switch S13, the fourteenth switch S14, the fifteenth switch S15, and the sixteenth switch S16 are all open, so that neither the second load 11013 nor the third load 11014 works.

Certainly, the gain of the second amplification module 110 may also be regulated by regulating quantities of working loads in the second-level inverter and the third-level inverter. This is not limited in this application.

Optionally, as shown in FIG. 6 and FIG. 7, the direct current offset current cancellation circuit 100 further includes a second filtering module 111. The second filtering module 111 is connected between the second amplification module 110 and the first end of the charging module 105, and is configured to stabilize an amplified direct current offset voltage output by the second amplification module 110, to stabilize a voltage at a second end of the direct current cancellation module 106.

The second filtering module 111 may be specifically a filter. The second filtering module 111 includes a capacitor. The second filtering module 111 and the charging module 105 share a capacitor. To be specific, the second filtering module 111 includes a second capacitor C2 in the charging module 105. In this way, slow increase of a cancellation voltage caused by excessive capacitors at the second end of the direct current cancellation module 106 can be avoided, and a rate at which the cancellation voltage reaches the direct current offset voltage is accelerated.

A first control signal may be further used for controlling switching of a time constant of the second filtering module 111. A control principle is switching of the time constant of the first filtering module 103, and therefore is not described herein again.

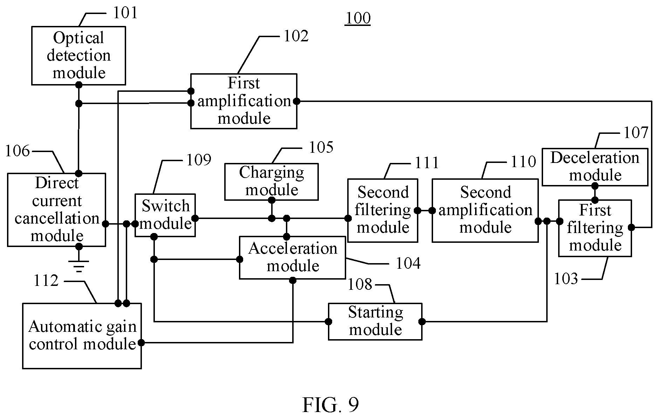

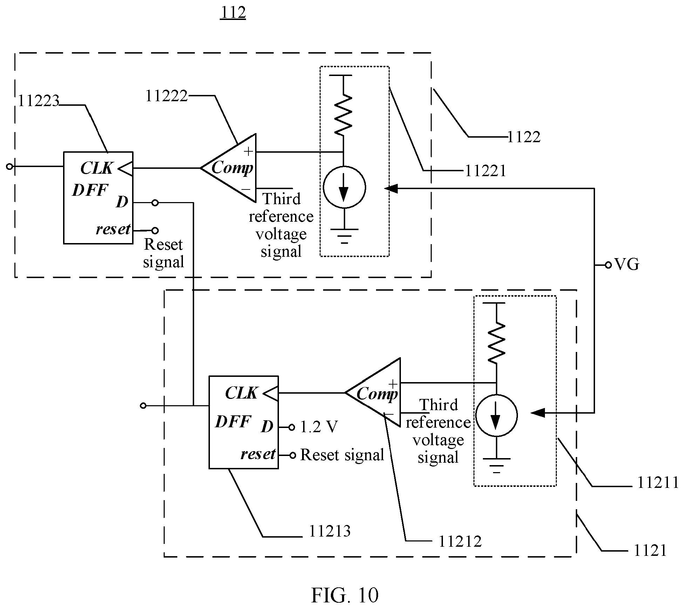

FIG. 9 is a schematic diagram of a structure of a fifth embodiment of a direct current offset current cancellation circuit according to an embodiment of this application. FIG. 10 is a schematic diagram of a structure of an automatic gain control module according to an embodiment of this application. As shown in FIG. 9, the direct current offset current cancellation circuit 100 in this embodiment further includes an automatic gain control module 112. An input end of the automatic gain control module 112 is connected to a second end of a direct current cancellation module 106, to obtain a cancellation voltage. An output end of the automatic gain control module 112 is connected to a first amplification module 102 to control a gain of the first amplification module 102.

The automatic gain control module 112 uses a direct current offset current canceled by an AOC loop as an input signal, determines a proportional relationship between the direct current offset current and an alternating current based on an extinction ratio of the input signal. A current mirror performs replication and mirrors a value of the alternating current through. When it is known that the extinction ratio of the input signal is ER (unit: decibel (dB)), and the direct current offset current $I_{dc}$ canceled by the AOC loop is, an alternating current $I_{ac}$ input to the first amplification module 102 at this time may be obtained by performing following calculation:

$$I_{ac} = 2I_{dc}\frac{RE-1}{RE+1}$$

$$RE = 10^{\frac{ER}{10}}$$

Because a dynamic range of strength of a current signal is large, to improve accuracy of current mirroring, the automatic gain control module 112 in this embodiment includes a first branch 1121 and a second branch 1122. The first branch and the second branch control two gain stages of the first amplification module 102 respectively. When a voltage generated by an alternating current that is mirrored by the first branch 1121 or the second branch 1122 and that flows through a resistor is higher than a value of a third reference voltage, the branch outputs a high level signal (that is, outputs a digit "1"), and the gain stage of the first amplification module 102 is switched.

As shown in FIG. 10, the first branch 1121 includes a first current mirror 11211, a third comparator 11212, and a third trigger 11213. The second branch 1122 includes a second current mirror 11221, a fourth comparator 11222, and a fourth trigger 11223. The first current mirror 11211 replicates, by using the cancellation voltage at a first preset proportion, the direct current offset current canceled by the AOC loop, and then mirrors, by using a replicated direct current offset current at a second preset proportion, a corresponding alternating current. The alternating current passes through a first load resistor, and a first mirror voltage is output. The second current mirror 11221 outputs a second mirror voltage in a same manner. The third comparator 11212 compares the first mirror voltage with the third reference voltage, and outputs a fourth rising edge signal to a clock control end of the third trigger 11213 when the first mirror voltage is greater than the third reference voltage. After being triggered by the fourth rising edge signal, the third trigger 11213 outputs a third high level signal (a digit "1") and latches the third high level signal.

The fourth comparator 11222 compares the second mirror voltage with the third reference voltage, and outputs a fifth rising edge signal to a clock control end of the fourth trigger 11223 when the second mirror voltage is greater than the third reference voltage. To avoid gain-across-stage triggering of the first amplification module 102, the third high level signal output by the third trigger 11213 is used as input of the fourth trigger 11223. In other words, a first input end of the fourth trigger 11223 is configured to receive the third high level signal, and a second input end of the fourth trigger 11223 is configured to receive a reset signal.

Therefore, when the third trigger 11213 outputs the third high level signal, the first input end of the fourth trigger 11223 is still at a low level. The fourth trigger 11223 outputs a low level signal (outputs a digit "0"). In this case, the digit "1" output by the third trigger 11213 and the digit "0" output by the fourth trigger 11223 are used as a third control signal.

After the fourth trigger 11223 is triggered by the fifth rising edge signal, and when the first input end of the fourth trigger 11223 receives the third high level signal and is at a high level, an output end of the fourth trigger 11223 outputs a fourth high level signal (a digit "1") and latches the fourth high level signal. In this case, the digit "1" output by the third trigger 11213 and the digit "1" output by the fourth trigger 11223 are used as a fourth control signal.

The third control signal and the fourth control signal are used for controlling a gain level of the first amplification module 102. That the first mirror voltage and the second mirror voltage are greater than the third reference voltage indicates that a current signal output by an optical detection module 101 is strong. Therefore, the gain of the first amplification module 102 can be reduced to prevent distortion of the output voltage signal caused by oversaturation the gain of the first amplification module 102. Therefore, the third control signal is used for controlling the gain of the first amplification module 102 to be switched from a high gain to a medium gain, and the fourth control signal is used for controlling the gain of the first amplification module 102 to be switched from the medium gain to a low gain. When a next reset signal arrives, the third trigger is reset, and the first amplification module restores to the maximum gain.

The fourth control signal is further used for controlling an acceleration module 104 to switch a status. Generation of the fourth signal can indicate that the current signal output by the optical detection module 101 is strong, and a direct current offset current is correspondingly large. Therefore, a direct current offset voltage is also large. To accelerate charging efficiency of a charging module 105, a target voltage provided by the acceleration module 104 for the charging module 105 needs to be increased. The fourth control signal is specifically used for controlling a third switch S3 to be closed and a fourth switch S4 to be open, so that a fourth capacitor C4 charges the charging module 105.

When detecting that the direct current offset current canceled by the AOC loop is greater than a current threshold, the automatic gain control module 112 further outputs a fifth control signal. The fifth control signal is used for controlling the acceleration module 104 to switch from a second status to a third status. The current threshold may be any value in 1.2 milliamperes to 1.8 milliamperes (mA).

In some other implementations, the gain of the first amplification module 102 and the status of the acceleration module 104 may alternatively be controlled by a signal recognition module (not shown). The signal recognition module is separately connected to the first amplification module 102 and the acceleration module 104. The signal recognition module receives an external input signal. The external input signal can be a signal that is specially introduced or a signal that is multiplexed on the reset signal. The signal recognition module may generate a corresponding control signal based on a pulse width of the external input signal, or may generate a corresponding control signal based on a level, which is not limited herein.

Specifically, the pulse width of the external input signal is proportional to strength of an optical signal. Alternatively, the level of the external input signal is proportional to the strength of the optical signal. There is a mapping relationship between the gain stage of the first amplification module 102 and the level or the pulse width of the external input signal. There is a mapping relationship between the status of the acceleration module 104 and the level or the pulse width of the external input signal. The signal recognition module may generate the corresponding control signal based on the pulse width and the level of the external input signal, to switch the gain stage of the first amplification module 102 or determine a target status of the acceleration module 104.

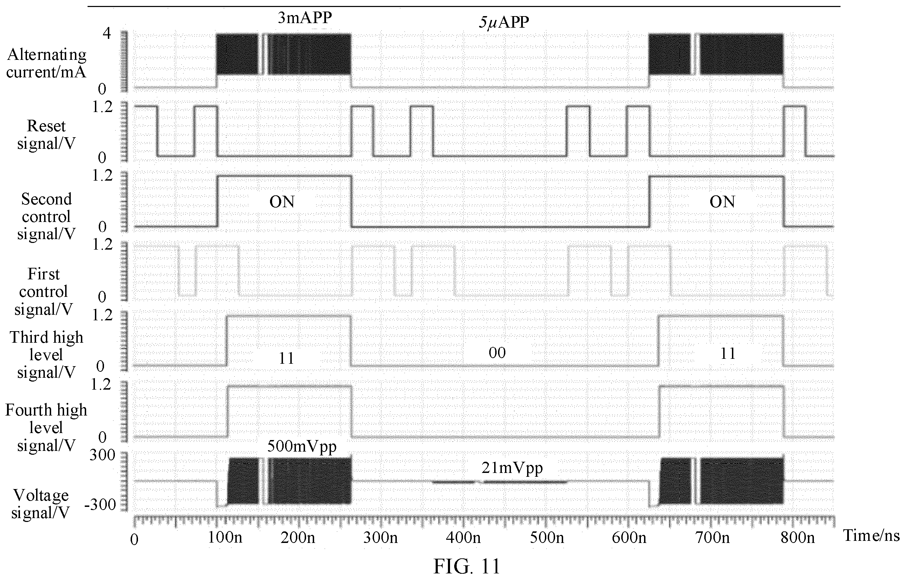

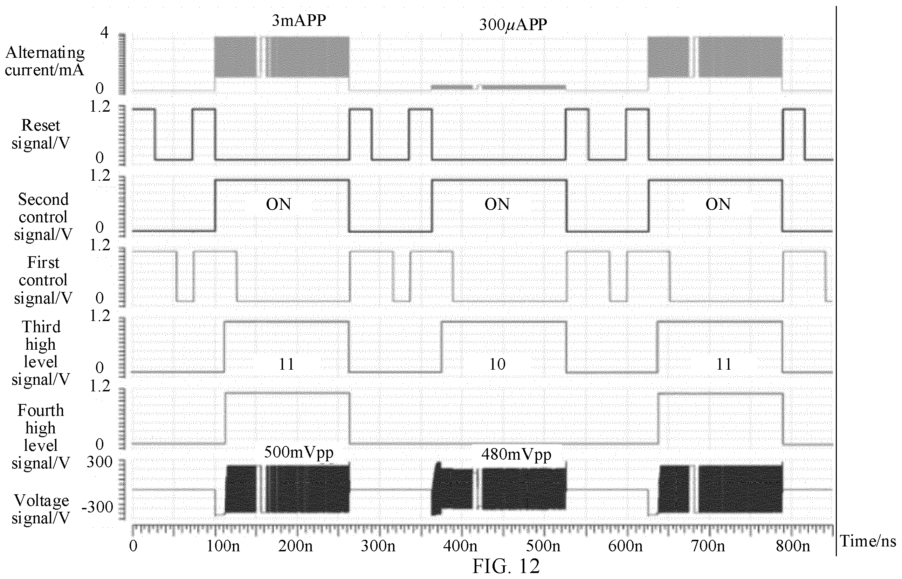

To more intuitively describe beneficial effects of embodiments of this application, a simulation diagram based on the fifth embodiment of the direct current offset current cancellation circuit is provided, as shown in FIG. 11 and FIG. 12. A horizontal coordinate indicates time, and a vertical coordinate indicates a voltage or a current.

FIG. 11 shows a working process of the AOC loop when a burst-mode signal (3 mApp-3 uApp-3 mApp) is input, where a reset signal is active high. When the alternating current in the current signal is 3 mA, a second control signal output by a starting module 108 is high, and the AOC loop is enabled to cancel a direct current offset current. The automatic gain control module 112 outputs a stage signal "11" (the fourth control signal, a lowest gain stage). When an input alternating current is 3 mA, the time that the AOC loop needs to stably extract the direct current offset current (that is, the cancellation voltage is the same as the direct current offset voltage) is 17 nanoseconds (ns). When the alternating current is 3 uApp, the second control signal output by the starting module 108 is low, the AOC loop does not work, and the AGC outputs a stage signal "00" (a highest gain stage).

FIG. 12 shows a working process of the AOC loop when a burst-mode signal (3 mApp-300 uApp-3 mApp) is input. When an input alternating current is 300 uApp, the AOC loop is in an open state. The automatic gain control module 112 outputs a stage signal "10" (the third control signal, a medium gain stage). When the input alternating current is 300 uApp the direct current offset current extracted by the AOC loop is 14 ns.

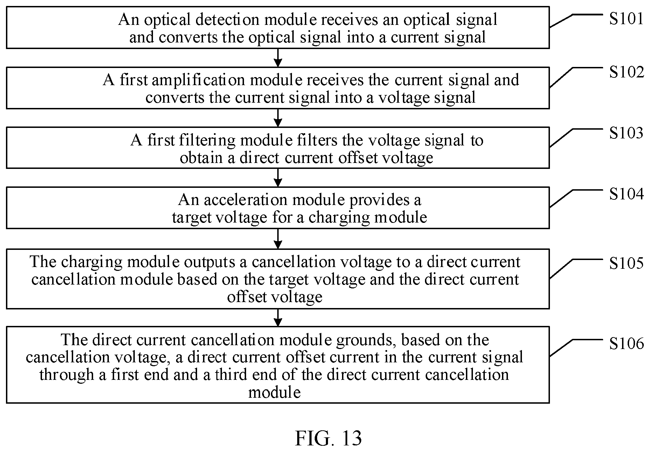

FIG. 13 is a schematic flowchart of an embodiment of a direct current offset current cancellation method according to this application. This embodiment is implemented based on the first embodiment of the direct current offset current cancellation circuit. This embodiment includes the following steps.

S101: An optical detection module receives an optical signal and converts the optical signal into a current signal.

S102: A first amplification module receives the current signal and converts the current signal into a voltage signal.

S103: A first filtering module filters the voltage signal to obtain a direct current offset voltage.

S104: An acceleration module provides a target voltage for a charging module.

S105: The charging module outputs a cancellation voltage to a direct current cancellation module based on the target voltage and the direct current offset voltage. The cancellation voltage is positively correlated with the target voltage and the direct current offset voltage.

S106: The direct current cancellation module grounds, based on the cancellation voltage, a direct current offset current in the current signal through a first end and a third end of the direct current cancellation module.

For specific content of S101 to S106 in this embodiment, reference may be made to the corresponding content of the first embodiment of the direct current offset current cancellation circuit. Details are not described herein again.

This application further provides a second embodiment of the direct current offset current cancellation method. This embodiment is implemented based on the second embodiment of the direct current offset current cancellation circuit. Compared with the first embodiment of the direct current offset current cancellation method, before S103, this embodiment further includes:

S203: A deceleration module switches a time constant of a first filtering module, to change filtering duration for filtering a direct current offset voltage.

For specific content, reference may be made to the corresponding content of the second embodiment of the direct current offset current cancellation circuit. Details are not described herein again.

This application further provides a third embodiment of the direct current offset current cancellation method. This embodiment is implemented based on the third embodiment of the direct current offset current cancellation circuit. Compared with the first embodiment of the direct current offset current cancellation method, before S104, this embodiment further includes:

S304: When determining that the direct current offset voltage is greater than or equal to a preset voltage, a starting module turns on a switch module, to enable a first filtering module to be connected to a direct current cancellation module. For specific content, reference may be made to the corresponding content of the third embodiment of the direct current offset current cancellation circuit. Details are not described herein again.

This application further provides a fourth embodiment of the direct current offset current cancellation method. This embodiment is implemented based on the fourth embodiment of the direct current offset current cancellation circuit. Compared with the first embodiment of the direct current offset current cancellation method, before S104, this embodiment further includes:

S404: A second amplification module amplifies the direct current offset voltage, and is configured to output an amplified direct current offset voltage to a charging module.

For specific content, reference may be made to the corresponding content of the fourth embodiment of the direct current offset current cancellation circuit. Details are not described herein again.

This application further provides a fifth embodiment of the direct current offset current cancellation method. This embodiment is implemented based on the fifth embodiment of the direct current offset current cancellation circuit. Compared with the first embodiment of the direct current offset current cancellation method, this embodiment further includes:

S507: An automatic gain control module controls, based on a magnitude of the direct current offset current grounded by the direct current cancellation module, switching of a gain of the first amplification module, and controls switching of a status of the acceleration module.

For specific content, reference may be made to the corresponding content of the fifth embodiment of the direct current offset current cancellation circuit. Details are not described herein again.

An embodiment of this application provides an optical receiver. The optical receiver includes the direct current offset current cancellation circuit in any one of the foregoing embodiments and a post amplification circuit. The post amplification circuit is connected to an output end of a first amplification module in the direct current offset current cancellation circuit, to further amplify a voltage signal.

Specifically, the post amplification circuit is connected to the output end of the first amplification module in the direct current offset current cancellation circuit to further amplify the voltage signal, to drive data corresponding to the voltage signal to be output from the optical receiver.

An embodiment of this application provides an optical switch. The optical switch includes the direct current offset current cancellation circuit in any one of the foregoing embodiments. A post amplification circuit is connected to an output end of the direct current offset current cancellation circuit. The post amplification circuit is configured to amplify a voltage signal output by the direct current offset current cancellation circuit.

An embodiment of this application provides a passive optical network system. The passive optical network system includes an optical transmitter and the foregoing optical receiver. The optical transmitter is configured to send an optical signal to the optical receiver. The optical receiver receives the optical signal and converts the optical signal into a current signal. The current signal includes a direct current offset current. The optical receiver includes the direct current offset current cancellation circuit in any one of the foregoing embodiments. The optical receiver cancels, based on the cancellation circuit, the direct current offset current corresponding to the optical signal.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

The foregoing describes the principles and implementations of this application by using specific examples. The foregoing embodiments are merely intended to help understand the method and the core idea of this application.

**Claims**

1. A direct current offset current cancellation circuit (100), wherein the cancellation circuit comprises an optical detection module (101), a first amplification module (102), a first filtering module (103), an acceleration module (104), a charging module (105), and a direct current cancellation module (106), wherein

   the optical detection module (101) having an output end that is connected to a first end of the direct current cancellation module (106) and the first amplification module (102), the first filtering module (103) is connected to the first amplification module (102) and the charging module (105), a second end of the direct current cancellation module (106) is connected to the acceleration module (104) and the charging module (105), and a third end of the direct current cancellation module (106) is grounded;
   the optical detection module (101) is configured to receive an optical signal and convert the optical signal into a current signal;
   the first amplification module (102) is configured to receive the current signal, convert and amplify the current signal into a voltage signal;
   the first filtering module (103) is configured to filter the voltage signal to obtain a direct current offset voltage;
   the acceleration module (104) is configured to accelerate a charging rate of the charging module (105) by sharing an electric charge to the charging module (105) in order to provide a target voltage for the charging module (105);
   the charging module (105) comprises a capacitor connected between the second end of the direct current cancellation module (106) and ground and is configured to output a cancellation voltage to the direct current cancellation module (106) based on the target voltage and the direct current offset voltage, wherein the cancellation voltage is positively correlated with the target voltage and the direct current offset voltage; and
   the direct current cancellation module (106) is configured to ground, based on the cancellation voltage, a direct current offset current in the current signal through the first end and the third end of the direct current cancellation module (106).

2. The circuit according to claim 1, wherein the acceleration module (104) is configured to provide the target voltage for the charging module (105) in a target status, the acceleration module (104) has a plurality of statuses, the target status is one of the plurality of statuses, and different statuses correspond to different voltages.

3. The circuit according to claim 2, wherein the target status is a preset status of the acceleration module (104), and a value of the target voltage is a minimum value in a plurality of voltages corresponding to the plurality of statuses.

4. The circuit according to claim 1 or 2, wherein the value of the target voltage is positively correlated with a value of the direct current offset voltage.

5. The circuit according to claim 4, wherein capacitance of the charging module (105) is negatively correlated with the value of the target voltage.

6. The circuit according to any one of claims 1 to 5, wherein the cancellation circuit further comprises a deceleration module (107), the deceleration module (107) is connected to the first filtering module (103), and the deceleration module (107) is configured to control a time constant for the first filtering module (103) to filter the voltage signal.

7. The circuit according to any one of claims 1 to 6, wherein the cancellation circuit further comprises a starting module (108) and a switch module (109), an input end of the starting module (108) is connected to an output end of the first filtering module (103) and an output end of the starting module (108) is connected to a control end of the switch module (109), the switch module (109) is connected between the first filtering module (103) and the second end of the direct current cancellation module (106), and the starting module (108) is configured to: when determining that the direct current offset voltage is greater than or equal to a first reference voltage, turn on the switch module (109), to enable the first filtering module (103) to be connected to the direct current cancellation module (106).

8. The circuit according to any one of claims 1 to 7, wherein the cancellation circuit further comprises a second amplification module (110), the second amplification module (110) is connected between the first filtering module (103) and the direct current cancellation module (106), and the second amplification module (110) is configured to amplify the direct current offset voltage and output an amplified direct current offset voltage to the charging module (105).

9. The circuit according to claim 8, wherein the cancellation circuit further comprises a second filtering module (111), the second filtering module (111) is connected between the second amplification module (110) and the direct current cancellation module (106), and the second filtering module (111) is configured to filter the amplified direct current offset voltage output by the second amplification module (110), and output a filtered direct current offset voltage to the charging module (105).

10. A direct current offset current cancellation method, applied to a cancellation circuit of a direct current offset current, wherein the cancellation circuit comprises an optical detection module (101), a first amplification module (102), a first filtering module (103), an acceleration module (104), a charging module (105), and a direct current cancellation module (106); the optical detection module (101) having an output end that is connected to a first end of the direct current cancellation module (106) and the first amplification module (102); the first filtering module (103) is connected to the first amplification module (102) and the charging module (105); a second end of the direct current cancellation module (106) is connected to the acceleration module (104) and the charging module (105); a third end of the direct current cancellation module (106) is grounded; and the method comprises:

receiving, by the optical detection module (101), an optical signal and converting the optical signal into a current signal;
receiving, by the first amplification module (102), the current signal and converting the current signal into a voltage signal;
filtering, by the first filtering module (103), the voltage signal to obtain a direct current offset voltage;
accelerating, by the acceleration module (104), a charging rate of the charging module (105) by sharing an electric charge to the charging module (105) in order to providing a target voltage for the charging module (105);
outputting, by the charging module (105), a cancellation voltage to the direct current cancellation module (106) based on the target voltage and the direct current offset voltage, wherein the cancellation voltage is positively correlated with the target voltage and the direct current offset voltage; and
grounding, by the direct current cancellation module (106) based on the cancellation voltage, a direct current offset current in the current signal through the first end and the third end of the direct current cancellation module (106).

11. The method according to claim 10, wherein the providing, by the acceleration module (104), a target voltage for the charging module (105) comprises:
providing, by the acceleration module (104) in a target status, the target voltage for the charging module (105), wherein the acceleration module (104) has a plurality of statuses, the target status is one of the plurality of statuses, and different statuses correspond to different voltages.

12. The method according to claim 11, wherein the target status is a preset status of the acceleration module (104), and a value of the target voltage is a minimum value in a plurality of voltages corresponding to the plurality of statuses.

13. The method according to claim 11, wherein the value of the target voltage is positively correlated with a value of the direct current offset voltage.

14. The method according to any one of claims 10 to 13, wherein the cancellation circuit further comprises a deceleration module (107), and the method further comprises:
controlling, by the deceleration module (107), a time constant for the first filtering module (103) to filter the voltage signal.

15. An optical receiver, comprising a post amplification circuit and the direct current offset current cancellation circuit according to any one of claims 1 to 9, wherein the post amplification circuit is connected to an output end of the direct current offset current cancellation circuit, and the post amplification circuit is configured to amplify a voltage signal output by the direct current offset current cancellation circuit.

**Patentansprüche**

1. Gleichstromversatzstrom-Unterdrückungsschaltung (100), wobei die Unterdrückungsschaltung ein optisches Detektionsmodul (101), ein erstes Verstärkungsmodul (102), ein erstes Filtermodul (103), ein Beschleunigungsmodul (104), ein Lademodul (105) und ein Gleichstromunterdrückungsmodul (106) umfasst, wobei

das optische Detektionsmodul (101) ein Ausgangsende besitzt, das mit einem ersten Ende des Gleichstromunterdrückungsmoduls (106) und dem ersten Verstärkungsmodul (102) verbunden ist, wobei das erste Filtermodul (103) mit dem ersten Verstärkungsmodul (102) und dem Lademodul (105) verbunden ist, ein zweites Ende des Gleichstromunterdrückungsmoduls (106) mit dem Beschleunigungsmodul (104) und dem Lademodul (105) verbunden ist und ein drittes Ende des Gleichstromunterdrückungsmoduls (106) geerdet ist;
das optische Detektionsmodul (101) konfiguriert ist, ein optisches Signal zu empfangen und das optische Signal in ein Stromsignal umzusetzen;
das erste Verstärkungsmodul (102) konfiguriert ist, das Stromsignal zu empfangen, und das Stromsignal in ein Spannungssignal umzusetzen und zu verstärken;
das erste Filtermodul (103) konfiguriert ist, das Spannungssignal zu filtern, um eine Gleichstromversatzspannung zu erhalten;
das Beschleunigungsmodul (104) konfiguriert ist, eine Laderate des Lademoduls (105) durch gemeinsames Nutzen einer elektrischen Ladung an das Lademodul (105) zu beschleunigen, um eine Zielspannung für das Lademodul (105) bereitzustellen;
das Lademodul (105) einen Kondensator umfasst, der zwischen dem zweiten Ende des Gleichstromunterdrückungsmoduls (106) und Erde angeschlossen ist und konfiguriert ist, eine Unterdrückungsspannung an das Gleichstromunterdrückungsmodul (106) anhand der Zielspannung und der Gleichstromversatzspannung auszugeben, wobei die Unterdrückungsspannung mit der Zielspannung und der Gleichstromversatzspannung positiv korreliert ist; und
das Gleichstromunterdrückungsmodul (106) konfiguriert ist, anhand der Unterdrückungsspannung einen Gleichstromversatzstrom in dem Stromsignal durch das erste Ende und das dritte Ende des Gleichstromunterdrückungsmoduls (106) zu erden.

2. Schaltung nach Anspruch 1, wobei das Beschleunigungsmodul (104) konfiguriert ist, die Zielspannung für das Lademodul (105) in einem Zielzustand bereitzustellen, wobei das Beschleunigungsmodul (104) mehrere Zustände besitzt, der Zielzustand einer der mehreren Zustände ist und verschiedene Zustände verschiedenen Spannungen entsprechen.

3. Schaltung nach Anspruch 2, wobei der Zielzustand ein voreingestellter Zustand des Beschleunigungsmoduls (104) ist und ein Wert der Zielspannung ein minimaler Wert in mehreren Spannungen ist, die den mehreren Zuständen entsprechen.

4. Schaltung nach Anspruch 1 oder 2, wobei der Wert der Zielspannung mit einem Wert der Gleichstromversatzspannung positiv korreliert ist.

5. Schaltung nach Anspruch 4, wobei die Kapazität des Lademoduls (105) mit dem Wert der Zielspannung negativ korreliert ist.

6. Schaltung nach einem der Ansprüche 1 bis 5, wobei die Unterdrückungsschaltung ferner ein Bremsmodul (107) umfasst, wobei das Bremsmodul (107) mit dem ersten Filtermodul (103) verbunden ist und das Bremsmodul (107) konfiguriert ist, eine Zeitkonstante für das erste Filtermodul (103) zu steuern, um das Spannungssignal zu filtern.

7. Schaltung nach einem der Ansprüche 1 bis 6, wobei die Unterdrückungsschaltung ferner ein Startmodul (108) und ein Schaltmodul (109) umfasst, wobei ein Eingangsende des Startmoduls (108) mit eine Ausgangsende des ersten Filtermoduls (103) verbunden ist und ein Ausgangsende des Startmoduls (108) mit einem Steuerende des Schaltmoduls (109) verbunden ist, wobei das Schaltmodul (109) zwischen dem ersten Filtermodul (103) und dem zweiten Ende des Gleichstromunterdrückungsmoduls (106) angeschlossen ist und das Startmodul (108) konfiguriert ist zum Einschalten des Schaltmoduls (109), um das erste Filtermodul (103) zu befähigen, mit dem Gleichstromunterdrückungsmodul (106) verbunden zu werden, wenn bestimmt wird, dass die Gleichstromversatzspannung größer oder gleich einer ersten Referenzspannung ist.

8.  Schaltung nach einem der Ansprüche 1 bis 7, wobei die Unterdrückungsschaltung ferner ein zweites Verstärkungsmodul (110) umfasst, wobei das zweite Verstärkungsmodul (110) zwischen dem ersten Filtermodul (103) und dem Gleichstromunterdrückungsmodul (106) angeschlossen ist und das zweite Verstärkungsmodul (110) konfiguriert ist, die Gleichstromversatzspannung zu verstärken und eine verstärkte Gleichstromversatzspannung an das Lademodul (105) auszugeben.

9.  Schaltung nach Anspruch 8, wobei die Unterdrückungsschaltung ferner ein zweites Filtermodul (111) umfasst, wobei das zweite Filtermodul (111) zwischen dem zweiten Verstärkungsmodul (110) und dem Gleichstromunterdrückungsmodul (106) angeschlossen ist und das zweite Filtermodul (111) konfiguriert ist, die durch das zweite Verstärkungsmodul (110) ausgegebene verstärkte Gleichstromversatzspannung zu filtern und eine gefilterte Gleichstromversatzspannung an das Lademodul (105) auszugeben.

10. Gleichstromversatzstrom-Unterdrückungsverfahren, das auf eine Unterdrückungsschaltung eines Gleichstromversatzstroms angewendet wird, wobei die Unterdrückungsschaltung ein optisches Detektionsmodul (101), ein erstes Verstärkungsmodul (102), ein erstes Filtermodul (103), ein Beschleunigungsmodul (104), ein Lademodul (105) und ein Gleichstromunterdrückungsmodul (106) umfasst; wobei das optische Detektionsmodul (101) ein Ausgangsende besitzt, das mit einem ersten Ende des Gleichstromunterdrückungsmoduls (106) und dem ersten Verstärkungsmodul (102) verbunden ist; wobei das erste Filtermodul (103) mit dem ersten Verstärkungsmodul (102) und dem Lademodul (105) verbunden ist; ein zweites Ende des Gleichstromunterdrückungsmoduls (106) mit dem Beschleunigungsmodul (104) und dem Lademodul (105) verbunden ist; ein drittes Ende des Gleichstromunterdrückungsmoduls (106) geerdet ist; und das Verfahren Folgendes umfasst:

Empfangen durch das optische Detektionsmodul (101) eines optischen Signals und Umsetzen des optischen Signals in ein Stromsignal;
Empfangen durch das erste Verstärkungsmodul (102) des Stromsignals und Umsetzen des Stromsignals in ein Spannungssignal;
Filtern durch das erste Filtermodul (103) des Spannungssignals, um eine Gleichstromversatzspannung zu erhalten;
Beschleunigen durch das Beschleunigungsmodul (104) einer Laderate des Lademoduls (105) durch gemeinsames Nutzen einer elektrischen Ladung an das Lademodul (105), um eine Zielspannung für das Lademodul (105) bereitzustellen;
Ausgeben durch das Lademodul (105) einer Unterdrückungsspannung an das Gleichstromunterdrückungsmodul (106) anhand der Zielspannung und der Gleichstromversatzspannung, wobei die Unterdrückungsspannung mit der Zielspannung und der Gleichstromversatzspannung positiv korreliert ist; und
Erden durch das Gleichstromunterdrückungsmodul (106) anhand der Unterdrückungsspannung eines Gleichstromversatzstroms in dem Stromsignal durch das erste Ende und das dritte Ende des Gleichstromunterdrückungsmoduls (106).

11. Verfahren nach Anspruch 10, wobei das Bereitstellen durch das Beschleunigungsmodul (104) einer Zielspannung für das Lademodul (105) Folgendes umfasst:
Bereitstellen durch das Beschleunigungsmodul (104) in einem Zielzustand der Zielspannung für das Lademodul (105), wobei das Beschleunigungsmodul (104) mehrere Zustände besitzt, wobei der Zielzustand einer der mehreren Zustände ist und verschiedene Zustände verschiedenen Spannungen entsprechen.

12. Verfahren nach Anspruch 11, wobei der Zielzustand ein voreingestellter Zustand des Beschleunigungsmoduls (104) ist und ein Wert der Zielspannung ein minimaler Wert in mehreren Spannungen ist, die den mehreren Zuständen entsprechen.

13. Verfahren nach Anspruch 11, wobei der Wert der Zielspannung mit einem Wert der Gleichstromversatzspannung positiv korreliert ist.

14. Verfahren nach einem der Ansprüche 10 bis 13, wobei die Unterdrückungsschaltung ferner ein Bremsmodul (107) umfasst und das Verfahren ferner Folgendes umfasst: Steuern durch das Bremsmodul (107) einer Zeitkonstanten für das erste Filtermodul (103), um das Spannungssignal zu filtern.

15. Optischer Empfänger, der eine Postverstärkungsschaltung und die Gleichstromversatzstrom-Unterdrückungsschaltung nach einem der Ansprüche 1 bis 9 umfasst, wobei die Postverstärkungsschaltung mit einem Ausgangsende der Gleichstromversatzstrom-Unterdrückungsschaltung verbunden ist und die Postverstärkungsschaltung konfiguriert ist, ein durch die Gleichstromversatzstrom-Unterdrückungsschaltung ausgegebenes Spannungssignal zu verstärken.

## Revendications

1. Circuit d'annulation de courant de décalage continu (100), dans lequel le circuit d'annulation comprend un module de détection optique (101), un premier module d'amplification (102), un premier module de filtrage (103), un module d'accélération (104), un module de charge (105) et un module d'annulation de courant continu (106), dans lequel

le module de détection optique (101) présente une extrémité de sortie qui est connectée à une première extrémité du module d'annulation de courant continu (106) et au premier module d'amplification (102), le premier module de filtrage (103) est connecté au premier module d'amplification (102) et au module de charge (105), une deuxième extrémité du module d'annulation de courant continu (106) est connectée au module d'accélération (104) et au module de charge (105), et une troisième extrémité du module d'annulation de courant continu (106) est mise à la terre ;
le module de détection optique (101) est configuré pour recevoir un signal optique et convertir le signal optique en un signal de courant ;
le premier module d'amplification (102) est configuré pour recevoir le signal de courant, convertir et amplifier le signal de courant en un signal de tension ;
le premier module de filtrage (103) est configuré pour filtrer le signal de tension afin d'obtenir une tension de décalage continue ;
le module d'accélération (104) est configuré pour accélérer une vitesse de charge du module de charge (105) en partageant une charge électrique avec le module de charge (105) afin de fournir une tension cible pour le module de charge (105) ;
le module de charge (105) comprend un condensateur connecté entre la deuxième extrémité du module d'annulation de courant continu (106) et la terre et est configuré pour délivrer une tension d'annulation au module d'annulation de courant continu (106) en fonction de la tension cible et de la tension de décalage continue, dans lequel la tension d'annulation est positivement corrélée avec la tension cible et la tension de décalage continue ; et
le module d'annulation de courant continu (106) est configuré pour mettre à la terre, en fonction de la tension d'annulation, un courant de décalage continu dans le signal de courant par le biais de la première extrémité et de la troisième extrémité du module d'annulation de courant continu (106).

2. Circuit selon la revendication 1, dans lequel le module d'accélération (104) est configuré pour fournir la tension cible pour le module de charge (105) dans un état cible, le module d'accélération (104) a une pluralité d'états, l'état cible est l'un de la pluralité d'états, et différents états correspondent à différentes tensions.

3. Circuit selon la revendication 2, dans lequel l'état cible est un état prédéfini du module d'accélération (104), et une valeur de la tension cible est une valeur minimale dans une pluralité de tensions correspondant à la pluralité d'états.

4. Circuit selon la revendication 1 ou 2, dans lequel la valeur de la tension cible est positivement corrélée avec une valeur de la tension de décalage de courant continu.

5. Circuit selon la revendication 4, dans lequel la valeur de capacité du module de charge (105) est négativement corrélée avec la valeur de la tension cible.

6. Circuit selon l'une quelconque des revendications 1 à 5, dans lequel le circuit d'annulation comprend en outre un module de décélération (107), le module de décélération (107) est connecté au premier module de filtrage (103) et le module de décélération (107) est configuré pour commander une constante de temps du premier module de filtrage (103) pour filtrer le signal de tension.

7. Circuit selon l'une quelconque des revendications 1 à 6, dans lequel le circuit d'annulation comprend en outre un module de départ (108) et un module de commutation (109), une extrémité d'entrée du module de départ (108) est connectée à une extrémité de sortie du premier module de filtrage (103) et une extrémité de sortie du module de départ (108) est connectée à une extrémité de commande du module de commutation (109), le module de commutation (109) est connecté entre le premier module de filtrage (103) et la deuxième extrémité du module d'annulation de courant continu (106), et le module de démarrage (108) est configuré pour : lorsqu'il est déterminé que la tension de décalage continue est supérieure ou égale à une première tension de référence, activer le module de commutation (109), pour permettre la connexion du premier module de filtrage (103) au module d'annulation de courant continu (106).

**8.** Circuit selon l'une quelconque des revendications 1 à 7, dans lequel le circuit d'annulation comprend en outre un second module d'amplification (110), le second module d'amplification (110) est connecté entre le premier module de filtrage (103) et le module d'annulation de courant continu (106), et le second module d'amplification (110) est configuré pour amplifier la tension de décalage continue et délivrer une tension de décalage continue amplifiée au module de charge (105).

**9.** Circuit selon la revendication 8, dans lequel le circuit d'annulation comprend en outre un second module de filtrage (111), le second module de filtrage (111) est connecté entre le second module d'amplification (110) et le module d'annulation de courant continu (106), et le second module de filtrage (111) est configuré pour filtrer la sortie de tension de décalage continue amplifiée par le second module d'amplification (110), et délivrer une tension de décalage continue filtrée au module de charge (105).

**10.** Procédé d'annulation de courant de décalage continu, appliqué à un circuit d'annulation d'un courant de décalage continu, dans lequel le circuit d'annulation comprend un module de détection optique (101), un premier module d'amplification (102), un premier module de filtrage (103), un module d'accélération (104), un module de charge (105) et un module d'annulation de courant continu (106) ; le module de détection optique (101) ayant une extrémité de sortie qui est connectée à une première extrémité du module d'annulation de courant continu (106) et au premier module d'amplification (102) ; le premier module de filtrage (103) est connecté au premier module d'amplification (102) et au module de charge (105) ; une deuxième extrémité du module d'annulation de courant continu (106) est connectée au module d'accélération (104) et au module de charge (105) ; une troisième extrémité du module d'annulation de courant continu (106) est mise à la terre ; et le procédé comprend :

la réception, par le module de détection optique (101), d'un signal optique et la conversion du signal optique en un signal de courant ; la réception, par le premier module d'amplification (102), du signal de courant et la conversion du signal de courant en un signal de tension ; le filtrage, par le premier module de filtrage (103), du signal de tension pour obtenir une tension de décalage continue ; l'accélération, par le module d'accélération (104), d'une vitesse de charge du module de charge (105) en partageant une charge électrique avec le module de charge (105) afin de fournir une tension cible pour le module de charge (105) ;

la délivrance, par le module de charge (105), d'une tension d'annulation au module d'annulation de courant continu (106) en fonction de la tension cible et de la tension de décalage continue, la tension d'annulation étant corrélée positivement avec la tension cible et la tension de décalage continue ; et
la mise à la terre, par le module d'annulation de courant continu (106) en fonction de la tension d'annulation, d'un courant de décalage continu dans le signal de courant par le biais de la première extrémité et de la troisième extrémité du module d'annulation de courant continu (106).

**11.** Procédé selon la revendication 10, dans lequel la fourniture, par le module d'accélération (104), d'une tension cible pour le module de charge (105) comprend :
la fourniture, par le module d'accélération (104) dans un état cible, de la tension cible pour le module de charge (105), dans lequel le module d'accélération (104) a une pluralité d'états, l'état cible est l'un de la pluralité d'états, et des états différents correspondent à des tensions différentes.

**12.** Procédé selon la revendication 11, dans lequel l'état cible est un état prédéfini du module d'accélération (104), et une valeur de la tension cible est une valeur minimale dans une pluralité de tensions correspondant à la pluralité d'états.

**13.** Procédé selon la revendication 11, dans lequel la valeur de la tension cible est positivement corrélée avec une valeur de la tension de décalage continue.

**14.** Procédé selon l'une quelconque des revendications 10 à 13, dans lequel le circuit d'annulation comprend en outre un module de décélération (107), et le procédé comprend en outre :
la commande, par le module de décélération (107), d'une constante de temps du premier module de filtrage (103) pour filtrer le signal de tension.

**15.** Récepteur optique, comprenant un circuit de post-amplification et le circuit d'annulation du courant de décalage continu selon l'une quelconque des revendications 1 à 9, dans lequel le circuit de post-amplification est connecté à une extrémité de sortie du circuit d'annulation du courant de décalage continu, et le circuit de post-amplification est configuré pour amplifier une sortie de signal de tension par le circuit d'annulation de courant de décalage continu.

<u>100</u>

FIG. 1

FIG. 2

FIG. 3

FIG. 4

FIG. 5

FIG. 6

FIG. 7

FIG. 8

FIG. 9

FIG. 10

FIG. 11

FIG. 12

```
┌─────────────────────────────────────────────────────┐
│   An optical detection module receives an optical    │ ── S101
│   signal and converts the optical signal into a      │
│              current signal                          │
└─────────────────────────────────────────────────────┘
                         ↓
┌─────────────────────────────────────────────────────┐
│  A first amplification module receives the current   │ ── S102
│  signal and converts the current signal into a       │
│               voltage signal                         │
└─────────────────────────────────────────────────────┘
                         ↓
┌─────────────────────────────────────────────────────┐
│    A first filtering module filters the voltage      │ ── S103
│  signal to obtain a direct current offset voltage    │
└─────────────────────────────────────────────────────┘
                         ↓
┌─────────────────────────────────────────────────────┐
│         An acceleration module provides a            │ ── S104
│       target voltage for a charging module           │
└─────────────────────────────────────────────────────┘
                         ↓
┌─────────────────────────────────────────────────────┐
│  The charging module outputs a cancellation voltage  │ ── S105
│  to a direct current cancellation module based on    │
│  the target voltage and the direct current offset    │
│                    voltage                           │
└─────────────────────────────────────────────────────┘
                         ↓
┌─────────────────────────────────────────────────────┐
│  The direct current cancellation module grounds,     │ ── S106
│  based on the cancellation voltage, a direct current │
│  offset current in the current signal through a      │
│  first end and a third end of the direct current     │
│               cancellation module                    │
└─────────────────────────────────────────────────────┘
```

FIG. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010178256 A

- US 2011031419 A1